# EUROPEAN PATENT APPLICATION

(11) **EP 1 447 905 A1**
(43) Date of publication of application: **18.08.2004**
(21) Application number: 01978966.8
(22) Date of filing: 31.10.2001
(51) Int. Cl.: H03D 1/18

(54) **POWER DETECTING CIRCUIT AND DEMODULATOR COMPRISING IT**

(71) Applicant: Sony Corporation, Tokyo 141-0001 (JP); Sony International (Europe) GmbH, 10785 Berlin (DE)
(72) Inventor: ABE, Masayoshi, c/o SONY CORPORATION, Tokyo 141-0001 (JP); SASHO, Noboru, c/o SONY CORPORATION, Tokyo 141-0001 (JP); KRUPEZEVIC, Dragan, c/o SONY INTERN. (EUROPE) GmbH, 10785 Berlin (DE); BRANKOVIC, Veselin, c/o SONY INTERN. (EUROPE) GmbH, 10785 Berlin (DE); RATNI, Mohamed, c/o SONY INTERN. (EUROPE) GmbH, 10785 Berlin (DE)
(74) Representative: Thévenet, Jean-Bruno
(86) International application number: PCT/JP2001/009539
(87) International publication number: WO 2003/038991

(57) **Abstract**

A high performance power detection circuit suitable to be made monolithic, being compact and low at cost, suitable to a radio-frequency operation in a wide band, having excellent linearity in detection characteristics, small fluctuation of detection characteristics against bias fluctuation, small fluctuation of detection characteristics against FET threshold voltage fluctuation and a small DC offset, which does not require an additional circuit even when a subsequent circuit has a balanced input; and a demodulator using the same. The power detection circuit uses two transistors (FET) Q101 and Q102 having approximately same characteristics, wherein a connection point of sources are connected to a resistor element R103 as a current source, are used as active elements; gates and drains of the transistors Q101 and Q102 are supplied with approximately same bias voltages; drains of them are supplied with approximately same drain bias voltages; a capacitor C104, wherein a capacitance value is set to be a sufficiently large value, is connected between sources of transistors Q101 and Q102 and a ground; capacitors C102 and C103, wherein capacitance values are approximately same and set to be sufficiently large values, are connected between drains of the transistors Q101 and Q102 and a ground; a radio-frequency signal RFin is supplied to a gate of the transistor Q101; and a voltage difference between a drain of the transistor Q101 and a drain of the transistor Q102 is regarded as a detection output.

## Description

### TECHNICAL FIELD

The present invention relates to a power detection circuit used in a communication apparatus for transmitting/receiving a radio-frequency signal and a measurement device for measuring a signal level of a radio-frequency signal, and a demodulator using the same.

### BACKGOUND ART

In a conventional radio-frequency power detection circuit, mainly a Schottky barrier diode is often used.

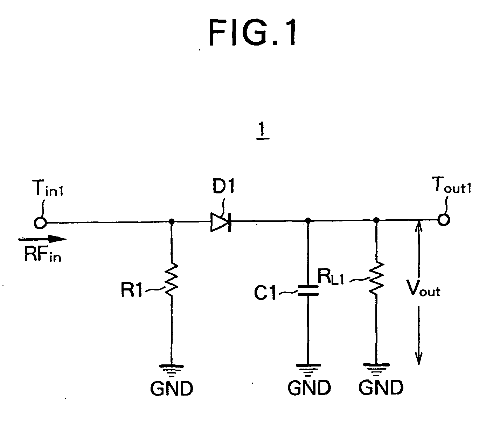

FIG. 1 is a circuit diagram showing a configuration of an example of a conventional radio-frequency power detection circuit using the diode.

As shown in FIG. 1, the radio-frequency power detection circuit 1 comprises a diode D1 as an active element, a direct-current bias resistor element R1, a capacitor C1 and a load resistor element RL1.

An anode of the diode D1 is connected to an input terminal Tin1 of a radio-frequency signal RFin and one end of the resistor element R1, and a cathode thereof is connected to an output terminal Tout1, one electrode of the capacitor C1 for removing radio-frequency components, and one end of the load resistor element RL1. Also, the other ends of the resistor elements R1 and RL1 and the other electrode of the capacitor C1 are grounded.

In the radio-frequency power detection circuit 1 having the above configuration, the radio-frequency signal RFin applied input to the input terminal Tin1. Due to rectification by the diode D1 and the capacitor C1 having a sufficiently large capacitance, envelope components of the input radio-frequency signal is output as a detection output signal Vout.

In the radio-frequency power detection circuit 1, it is required to obtain a detection output voltage Vout having a linearity from the lowest possible signal level to the highest possible signal level, that is, having a wide dynamic range.

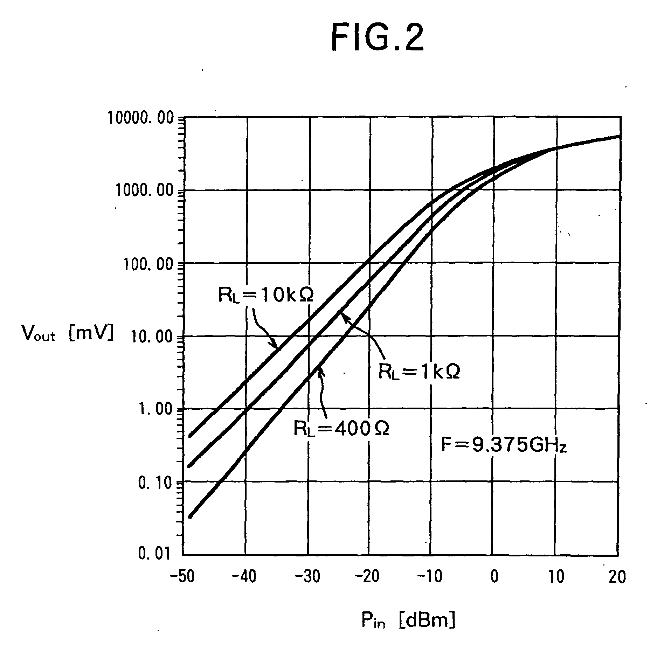

FIG. 2 is a view showing an example of characteristics of a radio-frequency power detection circuit using a diode as an active element.

In this example, a Schottky barrier diode is used, a bias voltage Vd of the diode D1 in FIG. 1 is set at 0V (Vd=0V: zero bias), and the relationship of an output voltage Vout with an input radio-frequency power Pin obtained when a frequency of a radio-frequency signal is 10 GHz, is plotted.

The conventional power detection circuit using a Schottky barrier diode having the above characteristics suffers from the disadvantages below.

A special semiconductor process is used for producing the circuit in order to improve a detection performance. Accordingly, the conventional power detection circuit as above is not suitable to form an integrated circuit.

From the above reason, the above conventional power detection circuit has to have a hybrid configuration. This results in the rising of production costs, limitation of an operation range and an increase of production variation.

When the above power detection circuit is configured in a semiconductor process capable of making an integrated circuit, the detection characteristic may be deteriorated.

In recent years, demands for a more compact radio communication device, such as a cellular phone, at a lower cost have been strong, and the realization of an integrated circuit is significant as a means to satisfy the demands.

Then, to obtain a high performance and radio-frequency power detection circuit suitable to form an integrated circuit, a power detection circuit using a field effect transistor (FET) as an active element has been studied.

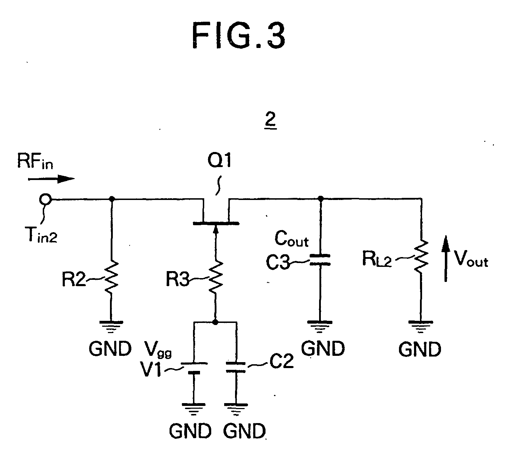

FIG. 3 is a circuit diagram of a configuration example of a conventional radio-frequency power detection circuit using a silicon (Si) MOSFET.

As shown in FIG. 3, the radio-frequency power detection circuit 2 comprises a field-effect transistor (hereinafter, simply referred to as a transistor) Q1, resistor elements R2 and R3, capacitors C2 and C3, a voltage source V1 and a load resistor element RL2.

In the radio-frequency power detection circuit 2, a gate of the transistor Q1 is biased by a bias supply circuit composed of the voltage source V1, the resistor element R3 and the capacitor C2. The input radio-frequency signal RFin propagates the transistor Q1 having a predetermined resistance between a drain and a source, and an envelope component of the input radio-frequency signal is output as a detection output signal Vout by the capacitor C3 on the output side having a large capacitance.

However, the radio-frequency power detection circuit in FIG. 3 suffers from the disadvantages below.

Since a Si MOSFET is used, the maximum operation frequency is as low as 1.5 GHz band.

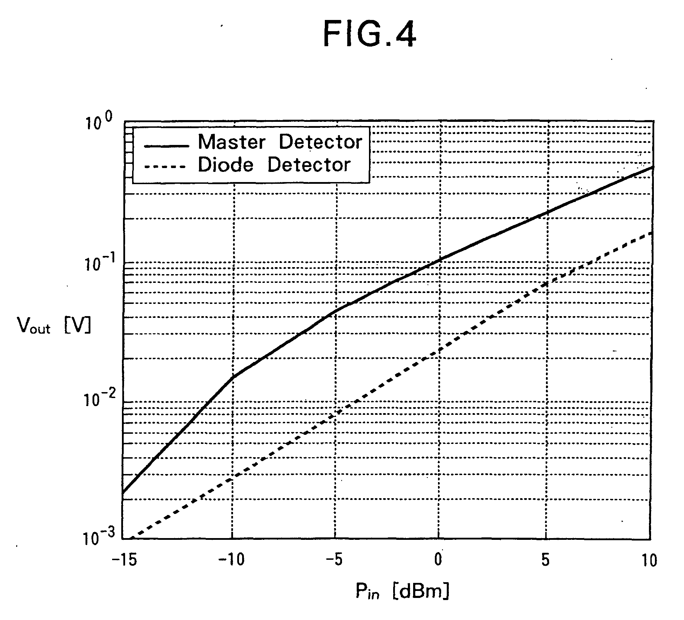

Also, as shown in FIG. 4, there is a possibility for improvement in a linearity of the characteristics of an input power to a detection output voltage (Mohamed RANTI, Bernard HUYART, et. al. "RF Power Detector using a Silicon MOSFET", International Microwave Symposium, 1998).

Also, when the power detection circuit 2 has an output type of a single end type, and a subsequent stage of a linear detection circuit has a balanced input, an additional imbalance/balance conversion circuit becomes necessary.

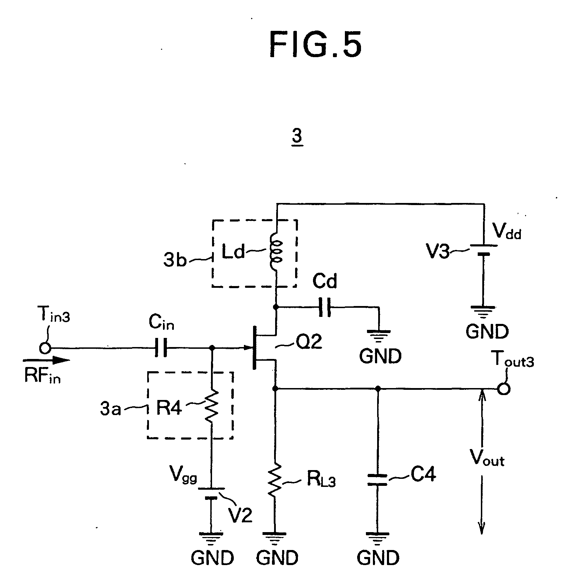

FIG. 5 is a circuit diagram showing another configuration example of a radio-frequency power detection circuit using a field-effect transistor as an active element (refer to The Japanese Unexamined (Kokai) Patent Publication No. 10-234474).

As shown in FIG. 5, the radio-frequency power detection circuit 3 comprises a transistor (FET) Q2, a DC cut capacitor Cin, a bias resistor element R4, voltage sources V2 and V3, a load resistor element RL3, an output side capacitor C4, a coupling capacitor Cd and an inductor Ld. The resistor element R4 configures a gate bias supply circuit 3a, and the inductor Ld configures a drain bias supply circuit 3b.

In the radio-frequency power detection circuit 3, a radio-frequency signal RFin input to an input terminal Tin3 is supplied to a gate of the transistor Q2 via the DC cut capacitor Cin. Also, the gate of the transistor Q2 is supplied with a gate bias voltage by the gate bias supply circuit 3a connected to the voltage source V2 supplying a voltage of Vgg. Also, a drain of the transistor Q2 is connected to the drain bias supply circuit 3b for supplying a drain bias voltage. Note that the drain bias supply circuit 3b is connected to a voltage source V3 for supplying a DC voltage Vdd.

The coupling capacitor Cd having a sufficiently large capacitance value is connected between a drain of the transistor Q2 and the ground potential GND. The resistor element RL3 and the coupling capacitor C4 having a sufficiently large capacitance value are connected in parallel between a source of the transistor Q2 and the ground potential GND. A potential difference Vout between the transistor Q2 and the ground potential GND defines a detection output signal.

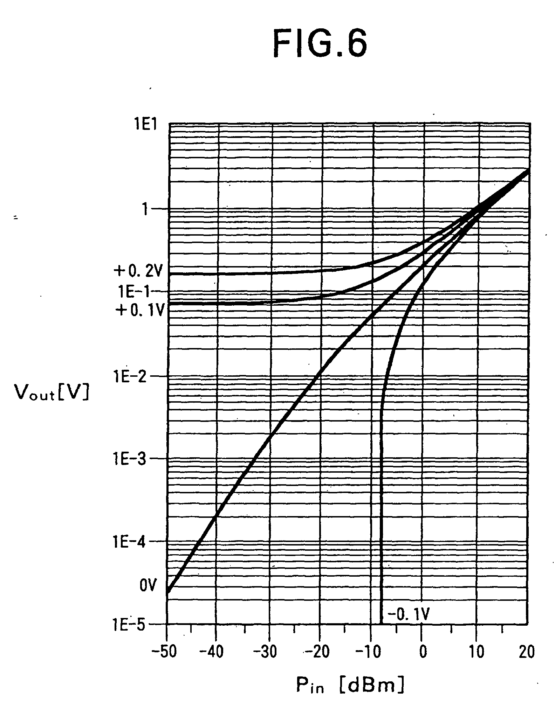

FIG. 6 shows the detection characteristics of the radio-frequency power detection circuit in FIG. 5.

While the power detection circuit 3 can realize a compact detection circuit suitable for a radio-frequency operation of a wide band at a low cost, it suffers from the disadvantages below.

As shown in FIG. 6, the fluctuation of characteristics in a detection output voltage to input power is large against the gate/source bias fluctuation.

Also, as shown in FIG. 6, the DC offset may arise in some cases depending on the bias condition.

When a pinch-off voltage of the transistor Q2 is changed due to the production variations and temperature changes, the variation of characteristics in a detection output voltage to input power becomes large.

Also, when the output type of the power detection circuit 3 is a single end type and a subsequent stage of a linear detection circuit thereof has a balanced input, an additional imbalance/balance conversion circuit is required.

### DISCLOSURE OF THE INVENTION

The present invention was made in consideration of the above circumstances and an object thereof is to provide a high-performance power detection circuit suitable to be made monolithic, formed a compact and low at cost, and suitable to a radio-frequency operation in a wide band, moreover, which has an excellent linearity of detection characteristics, exhibits a small variation of detection characteristics against a bias variation and small variation against FET threshold voltage variation, has a small DC offset, and does not require an additional circuit even when a subsequent stage circuit has a balanced input; and a demodulator using the same.

A first aspect of the present invention is a power detection circuit for detecting a signal level of a radio-frequency signal, comprising a first field-effect transistor having a gate supplied with the radio-frequency signal; a second field-effect transistor having a source connected to a source of the first field-effect transistor; a first gate bias supply circuit for supplying a gate bias voltage to a gate of the first field-effect transistor; a second gate bias supply circuit for supplying a gate bias voltage to a gate of the second field-effect transistor; a current source connected between a connection point of sources of the first field-effect transistor and second field-effect transistor and a reference potential; a first capacitor connected in parallel with the current source between a connection point of sources of the first field-effect transistor and second field-effect transistor and a reference potential; a drain bias supply circuit for supplying a drain bias voltage to drains of the first field-effect transistor and second field-effect transistor; a second capacitor connected between a drain of the first field-effect transistor and a reference potential; and a third capacitor connected between a drain of the second field-effect transistor and a reference potential, wherein a voltage difference between a drain voltage of the first field-effect transistor and a drain voltage of the second field-effect transistor is defined as a detection output.

A second aspect of the present invention is a power detection circuit for detecting a signal level of a radio-frequency signal, comprising a first field-effect transistor having a gate supplied with the radio-frequency signal; a second field-effect transistor having a source connected to a source of the first field-effect transistor; a first gate bias supply circuit for supplying a gate bias voltage to a gate of the first field-effect transistor; a second gate bias supply circuit for supplying a gate bias voltage to a gate of the second field-effect transistor; a current source connected between a connection point of sources of the first field-effect transistor and second field-effect transistor and a reference potential; a first capacitor connected in parallel with the current source between a connection point of sources of the first field-effect transistor and second e-f transistor and a reference potential; a drain bias supply circuit for supplying a drain bias voltage to drains of the first field-effect transistor and second field-effect transistor; and a second capacitor connected between a drain of the first field-effect transistor and a drain of the second field-effect transistor, wherein a voltage difference between a drain voltage of the first field-effect transistor and a drain voltage of the second field-effect transistor is defined as a detection output.

A third aspect of the present invention is a power detection circuit for detecting a signal level of a radio-frequency signal, comprising a first field-effect transistor having a gate supplied with the radio-frequency signal; a second field-effect transistor having a gate supplied with the radio-frequency signal and a source connected to a source of the first field-effect transistor; a first gate bias supply circuit for supplying a gate bias voltage to a gate of the first field-effect transistor; a second gate bias supply circuit for supplying a gate bias voltage to a gate of the second field-effect transistor; a current source connected between a connection point of sources of the first field-effect transistor and second field-effect transistor and a reference potential; a first capacitor connected in parallel with the current source between a connection point of sources of the first field-effect transistor and second e-f transistor and a reference potential; a drain bias supply circuit for supplying a drain bias voltage to drains of the first field-effect transistor and second field-effect transistor; a second capacitor connected between a drain of the first field-effect transistor and a reference potential; and a third capacitor connected between a drain of the second field-effect transistor and a reference potential; wherein a voltage difference between a drain voltage of the first field-effect transistor and a drain voltage of the second field-effect transistor is regarded as a detection output.

A fourth aspect of the present invention is a power detection circuit for detecting a signal level of a radio-frequency signal, comprising a first field-effect transistor having a gate supplied with the radio-frequency signal; a second field-effect transistor having a gate supplied with the radio-frequency signal and a source connected to a source of the first field-effect transistor; a first gate bias supply circuit for supplying a gate bias voltage to a gate of the first field-effect transistor; a second gate bias supply circuit for supplying a gate bias voltage to a gate of the second field-effect transistor; a current source connected between a connection point of sources of the first field-effect transistor and second field-effect transistor and a reference potential; a first capacitor connected in parallel with the current source between a connection point of sources of the first field-effect transistor and second e-f transistor and a reference potential; a drain bias supply circuit for supplying a drain bias voltage to drains of the first field-effect transistor and second field-effect transistor; and a second capacitor connected between a drain of the first field-effect transistor and a drain of the second field-effect transistor; wherein a voltage difference between a drain voltage of the first field-effect transistor and a drain voltage of the second field-effect transistor is detected and output.

In the first and third aspects, preferably, the first field-effect transistor and the second field-effect transistor have approximately the same characteristics; the drain bias supply circuit includes a first drain bias resistor element connected between a drain of the first field-effect transistor and a voltage source, and a second drain bias resistor element connected between a drain of the second field-effect transistor and a voltage source; a resistance value of the first drain bias resistor element and a resistance value of the second drain bias resistor element are set to be approximately same values; and a capacitance value of the second capacitor and a capacitance value of the third capacitor are set to be approximately the same values.

Also, in the first and third aspects, preferably, a ratio Wga/Wgb of a gate width Wga of the first field-effect transistor and a gate width Wgb of the second field-effect transistor is set to be N; the drain bias supply circuit includes a first drain bias resistor element connected between a drain of the first field-effect transistor and a voltage source, and a second drain bias resistor element connected between a drain of the second field-effect transistor and a voltage source; a first gate bias voltage by the first gate bias supply circuit and a second gate bias voltage by the second gate bias supply circuit are set to be approximately same; a resistance value Ra of the first drain bias resistor element and a resistance value Rb of the second drain bias resistor element are set to satisfy a condition of Ra/Rb = 1/N; and a capacitance value of the second capacitor and a capacitance value of the third capacitor are set to be approximately the same values.

In the second and fourth aspects, preferably, the first field-effect transistor and the second field-effect transistor have approximately the same characteristics; the drain bias supply circuit includes a first drain bias resistor element connected between a drain of the first field-effect transistor and a voltage source, and a second drain bias resistor element connected between a drain of the second field-effect transistor and a voltage source; a first gate bias voltage by the first gate bias supply circuit and a second gate bias voltage by the second gate bias supply circuit are approximately same and set at approximately same voltages as threshold voltages of the first and second field-effect transistors; and a resistance value of the first drain bias resistance element and a resistance value of the second drain bias resistor element are set to be approximately the same values.

Also, in the second and fourth aspects, preferably, a ratio Wga/Wgb of a gate width Wga of the first field-effect transistor and a gate width Wgb of the second field-effect transistor is set to be N; the drain bias supply circuit includes a first drain bias resistor element connected between a drain of the first field-effect transistor and a voltage source, and a second drain bias resistor element connected between a drain of the second field-effect transistor and a voltage source; a first gate bias voltage by the first gate bias supply circuit and a second gate bias voltage by the second gate bias supply circuit are approximately same and set at approximately same voltages as threshold voltages of the first and second field-effect transistors; and a resistance value Ra of the first drain bias resistor element and a resistance value Rb of the second drain bias resistor element are set to satisfy a condition of Ra/Rb = 1/N.

Also, a demodulator according to a fifth aspect of the present invention, comprises a first signal input terminal for receiving a first radio-frequency signal; a second signal input terminal for receiving a second radio-frequency signal; a generation means for generating two radio-frequency signals having a phase difference based on at least one of the first radio-frequency signal input from the first signal input terminal and the second radio-frequency signal input from the second signal input terminal, including at least one output terminal for outputting the generated radio-frequency signals; at least one power detection circuit for receiving the radio-frequency signal output from the output terminal of the generation means and detecting a signal level of the input radio-frequency signal; and a conversion circuit for converting an output signal of the power detection circuit to a plurality of signal components included in the first or second radio-frequency signal; wherein the power detection circuit comprises a first field-effect transistor having a gate supplied with the radio-frequency signal; a second field-effect transistor having a source connected to a source of the first field-effect transistor; a first gate bias supply circuit for supplying a gate bias voltage to a gate of the first field-effect transistor; a second gate bias supply circuit for supplying a gate bias voltage to a gate of the second field-effect transistor; a current source connected between a connection point of sources of the first field-effect transistor and the second field-effect transistor and a reference potential; a first capacitor connected in parallel with the current source between a connection point of sources of the first field-effect transistor and the second field-effect transistor and a reference potential; a drain bias supply circuit for supplying a drain bias voltage to drains of the first field-effect transistor and the second field-effect transistor; a second capacitor connected between a drain of the first field-effect transistor and a reference potential; and a third capacitor connected between a drain of the second field-effect transistor and a reference potential; wherein a voltage difference between a drain voltage of the first field-effect transistor and a drain voltage of the second field-effect transistor is regarded as a detection output.

A demodulator according to a sixth aspect of the present invention comprises a first signal input terminal for receiving a first radio-frequency signal; a second signal input terminal for receiving a second radio-frequency signal; a generation means for generating two radio-frequency signals having a phase difference based on at least one of the first radio-frequency signal input from the first signal input terminal and the second radio-frequency signal input from the second signal input terminal, including at least one output terminal for outputting the generated radio-frequency signals; at least one power detection circuit for receiving the radio-frequency signal output from the output terminal of the generation means and detecting a signal level of the input radio-frequency signal; and a conversion circuit for converting an output signal of the power detection circuit to a plurality of signal components included in the first or second radio-frequency signal; wherein the power detection circuit comprises: a first field-effect transistor having a gate supplied with the radio-frequency signal; a second field-effect transistor having a source connected to a source of the first field-effect transistor; a first gate bias supply circuit for supplying a gate bias voltage to a gate of the first field-effect transistor; a second gate bias supply circuit for supplying a gate bias voltage to a gate of the second field-effect transistor; a current source connected between a connection point of sources of the first field-effect transistor and the second field-effect transistor and a reference potential; a first capacitor connected in parallel with the current source between a connection point of sources of the first field-effect transistor and the second field-effect transistor and a reference potential; a drain bias supply circuit for supplying a drain bias voltage to drains of the first field-effect transistor and the second field-effect transistor; and a second capacitor connected between a drain of the first field-effect transistor and a drain of the second field-effect transistor, wherein a voltage difference between a drain voltage of the first field-effect transistor and a drain voltage of the second field-effect transistor is regarded as a detection output.

A demodulator according to a seventh aspect of the present invention comprises a first signal input terminal for receiving a first radio-frequency signal; a second signal input terminal for receiving a second radio-frequency signal; a generation means for generating two radio-frequency signals having a phase difference based on at least one of the first radio-frequency signal input from the first signal input terminal and the second radio-frequency signal input from the second signal input terminal, including at least one output terminal for outputting the generated radio-frequency signals; at least one power detection circuit for receiving the radio-frequency signal output from the output terminal of the generation means and detecting a signal level of the input radio-frequency signal; and a conversion circuit for converting an output signal of the power detection circuit to a plurality of signal components included in the first or second radio-frequency signal; wherein the power detection circuit comprises a first field-effect transistor having a gate supplied with the radio-frequency signal; a second field-effect transistor having a gate supplied with the radio-frequency signal and a source connected to a source of the first field-effect transistor; a first gate bias supply circuit for supplying a gate bias voltage to a gate of the first field-effect transistor; a second gate bias supply circuit for supplying a gate bias voltage to a gate of the second field-effect transistor; a current source connected between a connection point of sources of the first field-effect transistor and the second field-effect transistor and a reference potential; a first capacitor connected in parallel with the current source between a connection point of sources of the first field-effect transistor and the second field-effect transistor and a reference potential; a drain bias supply circuit for supplying a drain bias voltage to drains of the first field-effect transistor and the second field-effect transistor; a second capacitor connected between a drain of the first field-effect transistor and a reference potential; and a third capacitor connected between a drain of the second field-effect transistor and a reference potential; wherein a voltage difference between a drain voltage of the first field-effect transistor and a drain voltage of the second field-effect transistor is regarded as a detection output.

A demodulator according an eighth aspect of the present invention comprises a first signal input terminal for receiving a first radio-frequency signal; a second signal input terminal for receiving a second radio-frequency signal; a generation means for generating two radio-frequency signals having a phase difference based on at least one of the first radio-frequency signal input from the first signal input terminal and the second radio-frequency signal input from the second signal input terminal, including at least one output terminal for outputting the generated radio-frequency signals; at least one power detection circuit for receiving the radio-frequency signal output from the output terminal of the generation means and detecting a signal level of the input radio-frequency signal; and a conversion circuit for converting an output signal of the power detection circuit to a plurality of signal components included in the first or second radio-frequency signal; wherein the power detection circuit comprises a first field-effect transistor having a gate supplied with the radio-frequency signal; a second field-effect transistor having a gate supplied with a radio-frequency signal and a source connected to a source of the first field-effect transistor; a first gate bias supply circuit for supplying a gate bias voltage to a gate of the first field-effect transistor; a second gate bias supply circuit for supplying a gate bias voltage to a gate of the second field-effect transistor; a current source connected between a connection point of sources of the first field-effect transistor and the second field-effect transistor and a reference potential; a first capacitor connected in parallel with the current source between a connection point of sources of the first field-effect transistor and the second field-effect transistor and a reference potential; a drain bias supply circuit for supplying a drain bias voltage to drains of the first field-effect transistor and the second field-effect transistor; a second capacitor connected between a drain of the first field-effect transistor and a drain of the second field-effect transistor; and wherein a voltage difference between a drain voltage of the first field-effect transistor and a drain voltage of the second field-effect transistor is regarded as a detection output.

Preferably, the drain bias supply circuit can set a level of a drain bias voltage to a level in accordance with a control signal; further, a level detection circuit for detecting a reception signal level by a detection output of the power detection circuit; and a control circuit for generating the control signal to set the drain bias voltage to be supplied in accordance with a reception signal level detected in the level detection circuit and outputting to the drain bias supply circuit are included.

Also preferably, when a reception signal level is lower than a predetermined level, the control circuit outputs the control signal to set the drain bias voltage to be lower than that at the predetermined level.

According to the present invention, in the power detection circuit, a first field-effect transistor and a second field-effect transistor are used as active elements.

A radio-frequency signal is supplied to a gate of the first field-effect transistor, for example, via a matching circuit and a DC (direct current) cut capacitor.

Also, the gate of the first field-effect transistor is supplied with a gate bias voltage by a first gate bias supply circuit. In the same way, a gate of the second field-effect transistor is supplied with a gate bias voltage, for example, being approximately equal to the first gate bias voltage by a second gate bias supply circuit.

Also, between a connection point of a source of the first field-effect transistor and a source of the second field-effect transistor and the ground potential GND is connected a first capacitor C104 in parallel with a resistor element as a current source or a third field-effect transistor. A capacitance value of the first capacitor is set to be a sufficiently large value, so that the impedance becomes almost 0 ohm at higher frequencies including an input radio-frequency signal. As a result, sources of the first field-effect transistor and the second field-effect transistor become to be in a stable state in terms of radio-frequency.

Also, drains of the first field-effect transistor and the second field-effect transistor are supplied with drain bias voltages via resistor elements having approximately same resistance values, respectively.

Since second and third capacitors respectively having sufficiently large capacitor values are connected between the drains of the first field-effect transistor and second field-effect transistor and a reference potential (ground potential), drains of the first field-effect transistor and the second field-effect transistor become to be in a stable state in terms of a radio-frequency. A voltage difference between a voltage of the drain of the first field-effect transistor and that of the second field-effect transistor is supplied as a detection output signal to, for example, a conversion circuit on a subsequent stage.

### BRIEF DESCRIPTION OF DRAWINGS

FIG 1 is a circuit diagram showing a configuration example of a conventional radio-frequency power detection circuit using a diode.
FIG. 2 is a view showing a characteristic example of a radio-frequency power detection circuit using a diode as an active element.
FIG. 3 is a circuit diagram of a configuration example of a conventional radio-frequency power detection circuit using a silicon (Si) MOSFET.
FIG. 4 is a view of a characteristic example of the radio-frequency power detection circuit in FIG. 3 using a Si MOSFET.
FIG. 5 is a circuit diagram showing another configuration example of a radio-frequency power detection circuit using a field-effect transistor as an active element.
FIG. 6 is a view showing a detection characteristic of a radio-frequency power detection circuit using a field-effect transistor as an active element.
FIG. 7 is a circuit diagram showing a first embodiment of a radio-frequency power detection circuit according to the present invention.
FIG. 8 is a view showing an example of a detection characteristic of the radio-frequency power detection circuit in FIG. 7.
FIG. 9 is a view showing a radio-frequency power detection circuit having a circuit configuration wherein a capacitor C104 is not provided between a connection point of a source of a transistor Q101 and a source of a transistor Q102 and the ground potential GND in FIG. 7.
FIG. 10 is a circuit diagram showing a second embodiment of a radio-frequency power detection circuit according to the present invention.
FIG. 11 is a circuit diagram showing a third embodiment of a radio-frequency power detection circuit according to the present invention.
FIG. 12 is a circuit diagram showing a fourth embodiment of a radio-frequency power detection circuit according to the present invention.
FIG. 13 is a circuit diagram showing a fifth embodiment of a radio-frequency power detection circuit according to the present invention.
FIG. 14 is a circuit diagram showing a sixth embodiment of a radio-frequency power detection circuit according to the present invention.
FIG. 15 is a circuit diagram showing a seventh embodiment of a radio-frequency power detection circuit according to the present invention.
FIG. 16 is a circuit diagram showing an eighth embodiment of a radio-frequency power detection circuit according to the present invention.
FIG. 17 is a circuit diagram showing a configuration example of a 3-port demodulator which can apply a radio-frequency power detection circuit according to the present invention.
FIG. 18 is a circuit diagram showing a configuration example of a 4-port demodulator which can apply a radio-frequency power detection circuit according to the present invention.
FIG. 19 is a circuit diagram showing a configuration example of a 5-port demodulator which can apply a radio-frequency power detection circuit according to the present invention.
FIG. 20 is a circuit diagram showing a configuration example of a 6-port demodulator which can apply a radio-frequency power detection circuit according to the present invention.
FIG. 21 is a circuit diagram showing another configuration example of a 3-port demodulator which can apply a radio-frequency power detection circuit according to the present invention.
FIG. 22 is a view showing input power dependency of an output detection voltage of a radio-frequency power detection circuit in the case of changing a drain bias voltage in accordance with reception signal level information.
FIG. 23 is a circuit diagram showing another configuration example of a 4-port demodulator which can apply a radio-frequency power detection circuit according to the present invention.
FIG. 24 is a circuit diagram showing another configuration example of a 5-port demodulator which can apply a radio-frequency power detection circuit according to the present invention.
FIG. 25 is a circuit diagram showing another configuration example of a 6-port demodulator which can apply a radio-frequency power detection circuit according to the present invention.

### BEST MODE FOR CARRYING OUT THE INVENTION

Below, the preferred embodiments of the present invention will be explained with reference to the accompanying drawings.

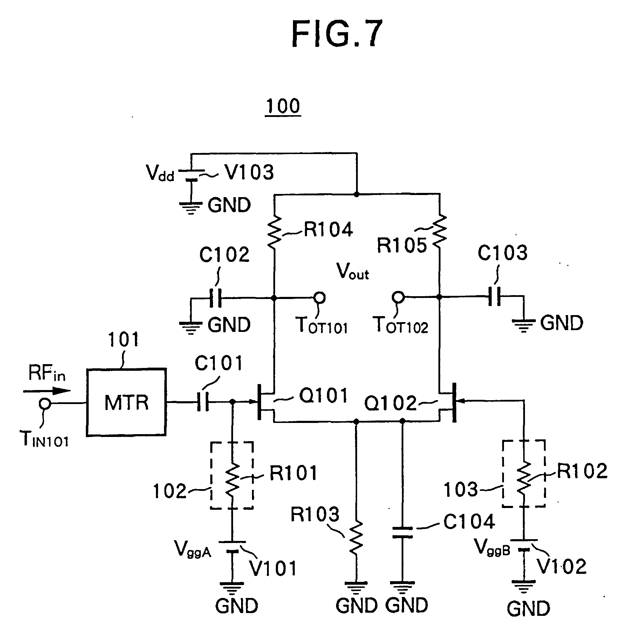

FIG. 7 is a circuit diagram showing a first embodiment of a radio-frequency power detection circuit according to the present invention.

A radio-frequency power detection circuit 100 according to the first embodiment comprises first and second field-effect transistors (hereinafter, referred to as a transistor) Q101 and Q102 as two active elements, capacitors C101, C102, C103 and C104, resistor elements R101, R102, R103 R104 and R105, voltage sources V101, V102 and V103, and a matching circuit (MTR) 101.

A gate of the transistor Q101 is connected to one electrode of a DC cut capacitor C101, and the other electrode of the capacitor C101 is connected to an input terminal TIN101 for a radio-frequency signal RFin via the matching circuit 101.

Also, a gate of the transistor Q101 is connected to an end of the resistor element R101, and the other end of the resistor element R101 is connected to the voltage source V101 having a voltage of VggA. The resistor element R101 configures a first gate bias supply circuit 102 for supplying a gate bias voltage of the transistor Q101.

A gate of the transistor Q102 is connected to one end of the resistor element 102, and the other end of the resistor element is connected to the voltage source V102 having a voltage of VggB. The resistor element R102 configures a second gate bias supply circuit 103 for supplying a gate bias voltage of the transistor Q102.

A source of the transistor Q101 and a source of the transistor Q102 are connected, and the connection point is connected to the ground potential GND via the resistor element R103 as a current source. Furthermore, between the connection point of the source of the transistor Q101 and the source of the transistor Q102 and the ground potential GND, a capacitor (first capacitor) C104 is connected in parallel with the resistor element R103.

Note that a capacitance value (capacitance) Css of the capacitor C104 is set to be a sufficiently large value, so that between the source terminals of the transistors Q101 and Q102 and the ground becomes equivalently short in a radio-frequency signal range. In other words, the capacitance Css of the capacitor C104 is set to be a sufficiently large value, so that the impedance becomes almost 0 ohm (Ω) in higher frequencies including an input radio-frequency signal RFin.

A drain of the transistor Q101 is connected to one end of the resistor element R104, one electrode of the capacitor (second capacitor) C102 and a first output terminal TOT101. The other end of the resistor element R104 is connected to a voltage source V103 having a voltage of Vdd, and the other electrode of the capacitor C102 is connected to the ground potential GND.

A drain of the transistor Q102 is connected to one end of the resistor element R105, one electrode of the capacitor C103 (third capacitor) and a second output terminal TOT102. The other end of the resistor element R105 is connected to the voltage source V103 having a voltage of Vdd, and the other electrode of the capacitor C103 is connected to the ground potential GND.

The drain of the transistor Q101 is supplied with a drain bias voltage via the resistor element R104, and the drain of the transistor Q102 is supplied with a drain bias voltage via the resistor element R105.

In the radio-frequency power detection circuit 100 configured to have the above connection relationship, the transistors Q101 and Q102 as active elements have the same device configuration to have almost the same characteristics.

A gate bias voltage by the gate bias supply circuit 102 and that by the gate bias supply circuit 103 are set to be approximately the same values. For example, a DC voltage VggA by the voltage source V101 and a DC voltage VggB by the voltage source V102 are set to be approximately the same values, and a resistance value of the resistor element R101 and that of the resistor element R102 are set to be approximately the same values.

Also, a resistance value Rda of the resistor element R104 and a resistance value Rda of the resistor element R105 connected to the drains of the transistors Q101 and Q102 satisfy a condition of Rda = Rdb. Similarly, a capacitance value Couta of the capacitor C102 and a capacitance value Coutb of the capacitor C103 satisfy a condition of Couta = Coutb.

Alternatively, in the radio-frequency power detection circuit 100, when assuming that the ratio (Wga/Wgb) of a gate width Wga of the transistor Q101 and the gate width Wgb of the transistor Q102 is N, conditions of Rda/Rdb = 1/N and Couta = Coutb are satisfied.

The capacitance values Couta and Coutb of the capacitors C102 and C103 are set to be sufficiently large values, so that the impedance becomes almost 0 ohm (Ω) in higher frequencies including an input radio-frequency signal Rfin having a frequency of "fin".

Also, in the gate bias supply circuits 102 and 103, it is preferable to isolate between gates of the transistors Q101 and Q102 and a voltage source at an input signal frequency of "fin".

Next, an operation in the above configuration will be explained.

A radio-frequency signal RFin input to the input terminal TIN101 is supplied to the gate of the transistor Q101 via the matching circuit 101 and the DC (direct current) cut capacitor C101.

Also, the gate of the transistor Q101 is supplied with a gate bias voltage by the gate bias supply circuit 102 connected to the voltage source V101 for supplying a voltage of Vgg. Similarly, the gate of the transistor Q102 is supplied with a gate bias voltage by the gate bias supply circuit 103 connected to the voltage source V102 for supplying a voltage of Vgg.

Also, between the connection point of sources of the transistor Q101 and transistor Q102 and the ground potential GND, a capacitor C104 is connected in parallel with the resistor element R103. Since a capacitance Css of the capacitor C104 is set to be a sufficiently large value, so that the impedance becomes almost 0 ohm (Ω) in higher frequencies including the input radio-frequency signal RFin, the sources of the transistors Q101 and Q102 become to be in a stable state in terms of the radio-frequency.

Also, drains of the transistors Q101 and Q102 are supplied with drain bias voltages via the resistor elements R104 and R105, respectively.

Since coupling capacitors C102 and C103 respectively having sufficiently large capacitance values are connected between the drains of the transistors Q101 and Q102 and the ground potential GND, drains of the transistor Q101 and transistor Q102 become to be in a stable state in terms of the radio-frequency, and a voltage difference between a voltage of the drain of the transistor Q101, that is a voltage of the first output terminal TOT101, and a voltage of the drain of the transistor Q102, that is a voltage of the second output terminal TOT102, is supplied as a detection output signal to a not shown processing circuit on a subsequent stage.

Below, the detection characteristics of the radio-frequency power detection circuit in FIG. 7 will be described with reference to drawings.

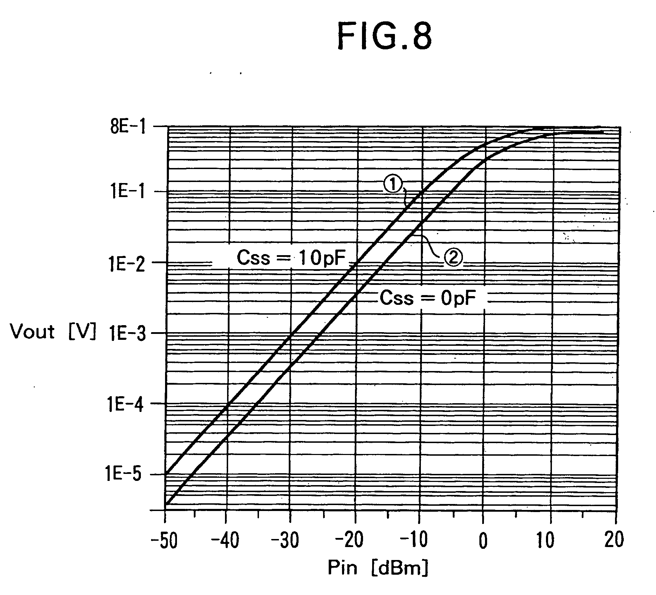

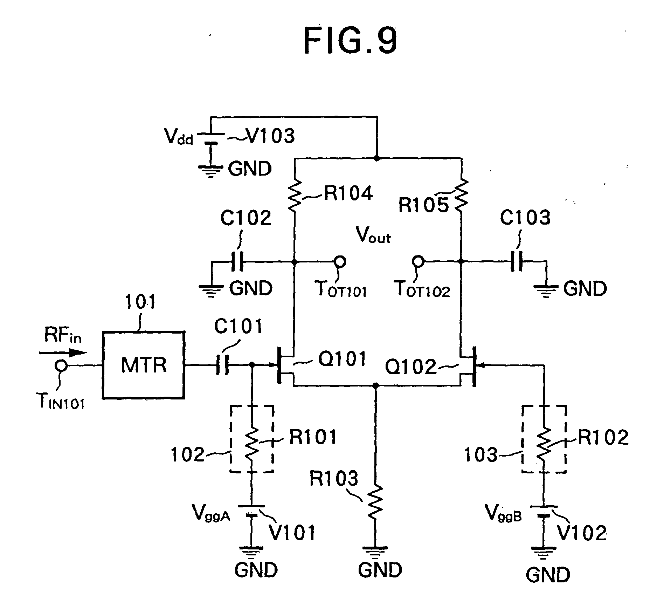

FIG. 8 is a view showing an example of detection characteristics of the radio-frequency power detection circuit in FIG. 7 and the detection characteristics of a radio-frequency power detection circuit in FIG. 9

The radio-frequency power detection circuit in FIG. 9 has a circuit configuration wherein a capacitor C104 is not provided between the connection point of the source of the transistor Q101 and the source of the transistor Q102 and the ground potential GND.

In FIG. 8, an abscissa indicates input radio-frequency power Pin and an ordinate indicates an output detection voltage Vout. A frequency of the input radio-frequency signal is 5.5 GHz. Also, in FIG. 8, characteristics of the power detection circuit in FIG. 7 is shown by a curve ①, and characteristics of the power detection circuit in FIG. 9 as comparative data is shown by a curve ②.

As is known from FIG. 8, the power detection circuit in FIG. 9 has a better linearity comparing with that of a conventional power detection circuit, but the power detection circuit in FIG. 7 has still a better linearity comparing with that of the power detection circuit in FIG. 9.

When the input power Pin = -10 dBm, an output detection voltage Vout = 24 mV in the circuit in FIG. 9, while in the circuit in FIG. 7, an output detection voltage Vout = 94 mV is obtained. Namely, the sensitivity is furthermore improved by about four times as much even when comparing with that in the circuit in FIG. 9 wherein sensitivity is improved comparing with the conventional circuit.

As explained above, according to the present first embodiment, as a result of configuring that two transistors (FET) Q101 and Q102 having approximately the same characteristics wherein sources thereof are connected and the connection point is connected to a resistor element R103 as a current source are used as active elements, gates of the transistors Q101 and Q102 are supplied with approximately equal gate bias voltages by the gate bias supply circuits 102 and 103, drains of the transistors Q101 and Q102 are supplied with approximately equal drain bias voltages, between the connection point of sources of the transistors Q101 and Q102 and the ground potential GND is connected a capacitor C104 as a first capacitor wherein a capacitance value is set to be a sufficiently large value so that the impedance becomes almost 0 ohm in higher frequencies including an input radio-frequency signal RFin, furthermore, between drains of the transistors Q101 and Q102 and the ground is connected capacitors C102 and C103 as second and third capacitors wherein capacitance values are set to be approximately equal and sufficiently large values so that the impedance becomes almost 0 ohm in higher frequencies including an input radio-frequency signal Rfin, the gate of the transistor Q101 is supplied with a radio-frequency signal RFin, and a voltage difference between the drain of the transistor Q101 and the drain of the transistor Q102 is regarded as a detection output, effects below are obtained.

Namely, comparing with a conventional detection circuit using a silicon Schottky diode, it is suitable to be made monolithic because it can be configured on a semiconductor process suitable to a radio-frequency, such as GaAs. Accordingly, a compact detection circuit suitable to a radio-frequency operation in a wide band can be realized at a low cost.

Also, comparing with the conventional power detection circuit, the power detection circuit in FIG. 7 has an advantage of realizing a high performance radio-frequency detection circuit having better linearity in detection characteristics, smaller fluctuation of detection characteristics against bias fluctuations, smaller fluctuation of detection characteristics against FET threshold voltage fluctuation, moreover, a smaller DC offset.

Also, since the power detection circuit in FIG. 7 has a balanced output, when the subsequent circuit has a balanced input, there is an advantage that the connection becomes easy.

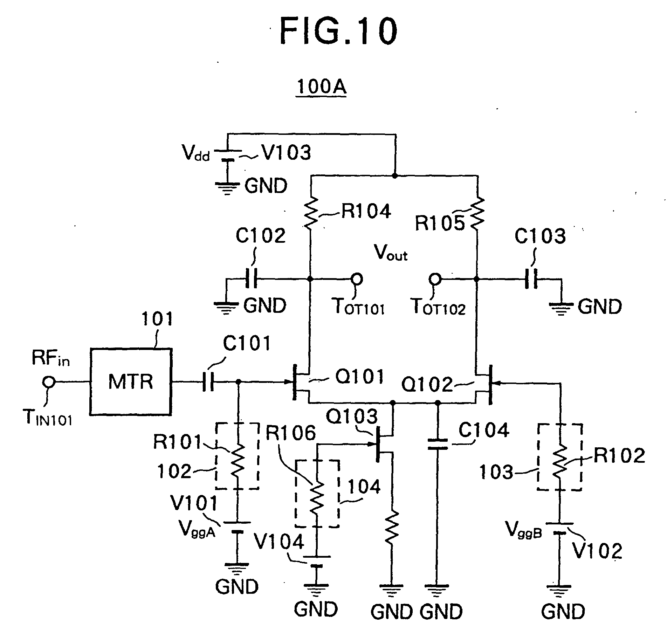

FIG. 10 is a circuit diagram showing a second embodiment of a radio-frequency power detection circuit according to the present invention.

A different point in the second embodiment from the first embodiment explained above is that instead of connecting a resistor element as a current source between the connection point of sources of the transistors Q101 and Q102 and the ground potential GND, a transistor Q103 as a third FET having a gate supplied with a bias voltage from the third gate bias supply circuit 104, is connected.

The gate bias supply circuit 104 is configured by a resistor element R106 connected between a gate of the transistor Q104 and the voltage source V104 having a voltage of VggC.

The other configuration in the second embodiment is the same as that in the first embodiment.

According to the second embodiment, the same effects as in the first embodiment can be obtained.

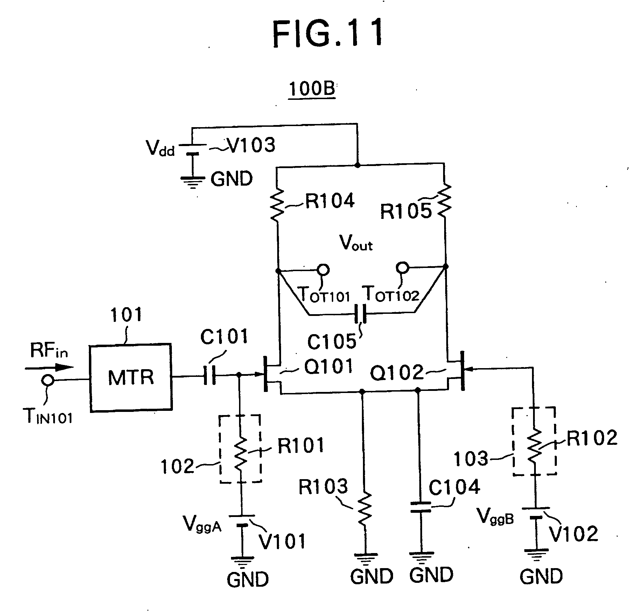

FIG. 11 is a circuit diagram showing a third embodiment of a radio-frequency power detection circuit according to the present invention.

The different points in the third embodiment to the first embodiment explained above are that instead of connecting the capacitors C102 and C103 between drains of the transistors Q101 and Q102 and the ground, a capacitor C105 (second capacitor) wherein the capacitance value is set to be a sufficiently large value so that the impedance becomes almost 0 ohm (Ω) in higher frequencies including an input radio-frequency signal Rfin is connected between a drain of the transistor Q101 and the drain of the transistor Q102.

The other configuration in the third embodiment is the same as that in the first embodiment.

According to the third embodiment, the same effects as in the first embodiment explained above are obtained, moreover, there are advantages that the number of parts can be reduced, and the fluctuation (variation) of drain potentials of the transistors Q101 and Q102 can be equalized.

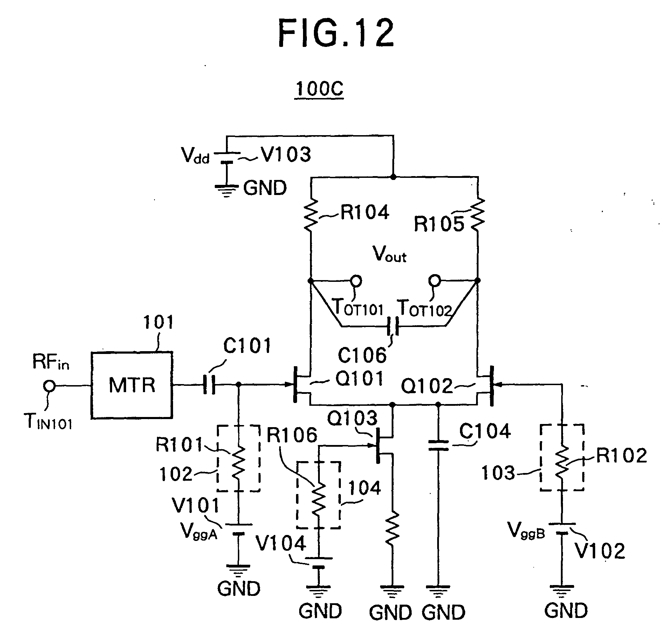

FIG. 12 is a circuit diagram showing a fourth embodiment of the radio-frequency power detection circuit according to the present invention.

A different point in the fourth embodiment from the second embodiment explained above is that instead of connecting the capacitors C102 and C103 between drains of the transistors Q101 and Q102 and the ground, a capacitor C106 (second capacitor), wherein the capacitance value is set to be a sufficiently large value so that the impedance becomes almost 0 ohm (Ω) in higher frequencies including an input radio-frequency signal Rfin, is connected between a drain of the transistor Q101 and the drain of the transistor Q102.

Other configuration in the fourth embodiment is the same as that in the second embodiment.

According to the fourth embodiment, the same effects as in the first embodiment explained above are obtained, moreover, there are advantages that the number of parts can be reduced, and the fluctuation of drain potentials of the transistors Q101 and Q102 can be equalized.

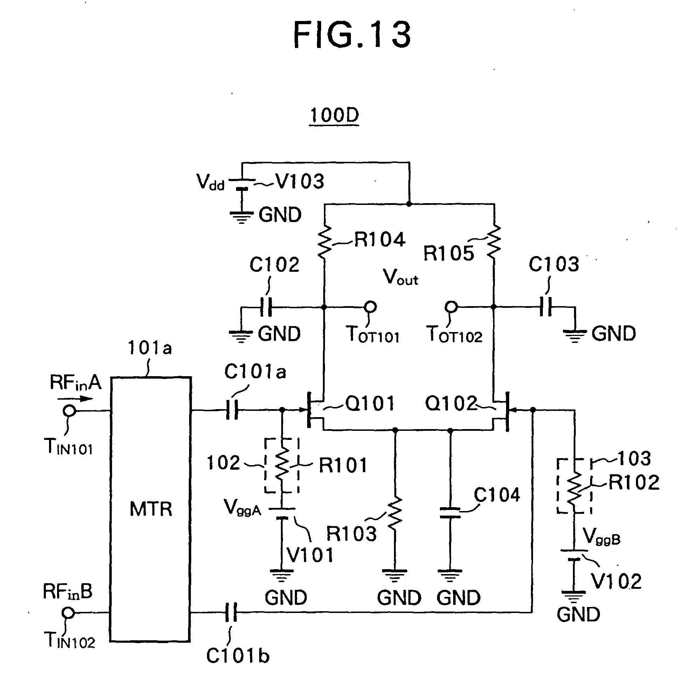

FIG. 13 is a circuit diagram showing a fifth embodiment of the radio-frequency power detection circuit according to the present invention.

A different point in the fifth embodiment from the first embodiment explained above is that the input form is not an unbalanced input but a balanced input.

Therefore, in a radio-frequency power detection circuit 100D according to the fifth embodiment, two input terminals TIN101 and TIN102 are connected on the input side of the matching circuit 101a, and two DC cut capacitors C101a and C101b are connected on the output side.

A gate of the transistor Q101 is supplied with a radio-frequency signal RFinA via the DC cut capacitor C101a, and a gate of the transistor Q102 is supplied with a radio-frequency signal RFinB via the DC cut capacitor C101b.

In the radio-frequency power detection circuit 100D according to the fifth embodiment, a differential power of the radio-frequency signal input RFinA and the radio-frequency signal input RFinB is detected and output.

The other configuration in the fifth embodiment is the same as that in the first embodiment.

According to the fifth embodiment, the same effects as in the first embodiment explained above are obtained.

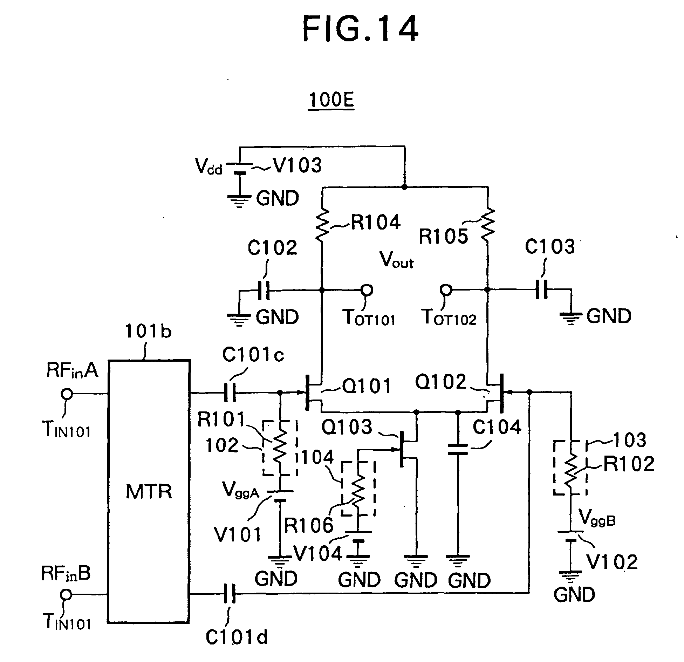

FIG. 14 is a circuit diagram showing a sixth embodiment of the radio-frequency power detection circuit according to the present invention.

A different point in the sixth embodiment from the second embodiment explained above is that the input form is not an unbalanced input but a balanced input.

Therefore, in a radio-frequency power detection circuit 100E according to the sixth embodiment, two input terminals TIN101 and TIN102 are connected on the input side of the matching circuit 101b, and two DC cut capacitors C101c and C101d are connected on the output side.

A gate of the transistor Q101 is supplied with a radio-frequency signal RFinA via the DC cut capacitor C101c, and a gate of the transistor Q102 is supplied with a radio-frequency signal RFinB via the DC cut capacitor C101d.

In the radio-frequency power detection circuit 100E according to the sixth embodiment, a differential power of the radio-frequency signal input RFinA and the radio-frequency signal input RFinB is detected and output.

The other configuration in the sixth embodiment is the same as that in the second embodiment.

According to the sixth embodiment, the same effects as in the first embodiment explained above are obtained.

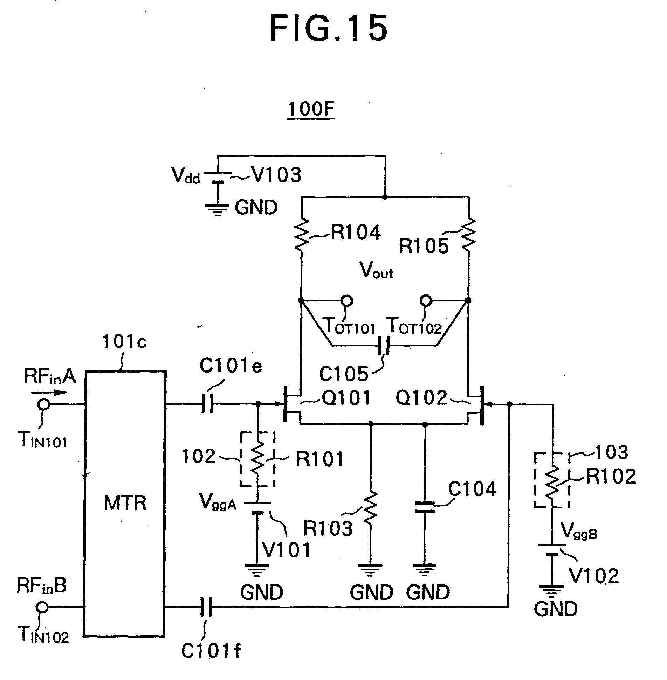

FIG. 15 is a circuit diagram showing a seventh embodiment of the radio-frequency power detection circuit according to the present invention.

A different point in the seventh embodiment from the third embodiment explained above is that the input form is not an unbalanced input but a balanced input.

Therefore, in a radio-frequency power detection circuit 100F according to the seventh embodiment, two input terminals TIN101 and TIN102 are connected on the input side of the matching circuit 101b, and two DC cut capacitors C101e and C101f are connected on the output side.

A gate of the transistor Q101 is supplied with a radio-frequency signal RFinA via the DC cut capacitor C101e, and a gate of the transistor Q102 is supplied with a radio-frequency signal RFinB via the DC cut capacitor C101f.

In the radio-frequency power detection circuit 100F according to the seventh embodiment, a differential power of the radio-frequency signal input RFinA and the radio-frequency signal input RFinB is detected and output.

The other configuration in the seventh embodiment is the same as that in the third embodiment.

According to the seventh embodiment, the same effects as in the first embodiment explained above can be obtained.

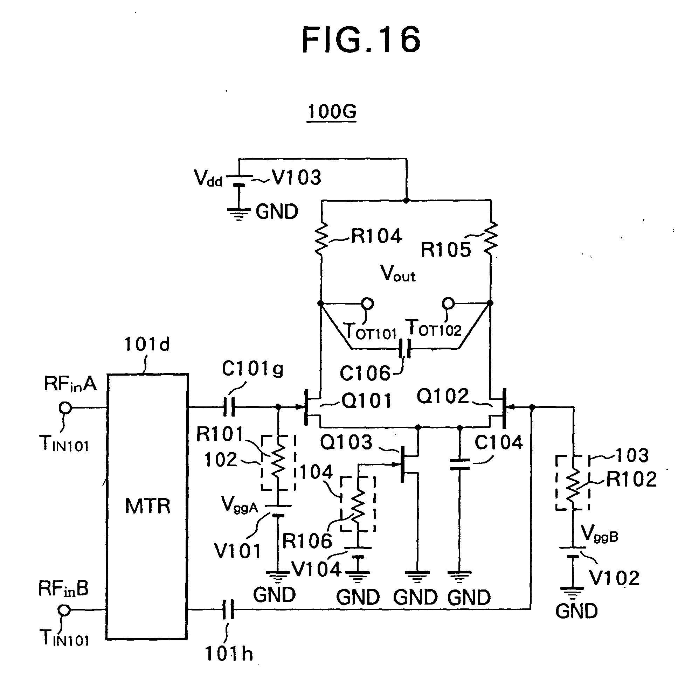

FIG. 16 is a circuit diagram showing an eighth embodiment of the radio-frequency power detection circuit according to the present invention.

A different point in the eighth embodiment from the fourth embodiment explained above is that the input form is not an unbalanced input but a balanced input.

Therefore, in a radio-frequency power detection circuit 100G according to the eighth embodiment, two input terminals TIN101 and TIN102 are connected on the input side of the matching circuit 101d, and two DC cut capacitors C101g and C101h are connected on the output side.

A gate of the transistor Q101 is supplied with a radio-frequency signal RFinA via the DC cut capacitor C101g, and a gate of the transistor Q102 is supplied with a radio-frequency signal RFinB via the DC cut capacitor C101h.

In the radio-frequency power detection circuit 100G according to the eighth embodiment, a differential power of the radio-frequency signal input RFinA and the radio-frequency signal input RFinB is detected and output.

The other configuration in the eighth embodiment is the same as that in the fourth embodiment.

According to the eighth embodiment, the same effects as in the first embodiment explained above are obtained.

A variety of embodiments of the radio-frequency power detection circuit according to the present invention were explained as the first to eighth embodiments above.

Below, an N-port demodulator capable of applying the radio-frequency power detection circuit according to the present invention will be explained. Note that instead of eight reference numbers 100, 100A to 100G used in the above explanation, a radio-frequency power detection circuit (PD) is referred to by a reference number 100H indicating to include any one of the circuits.

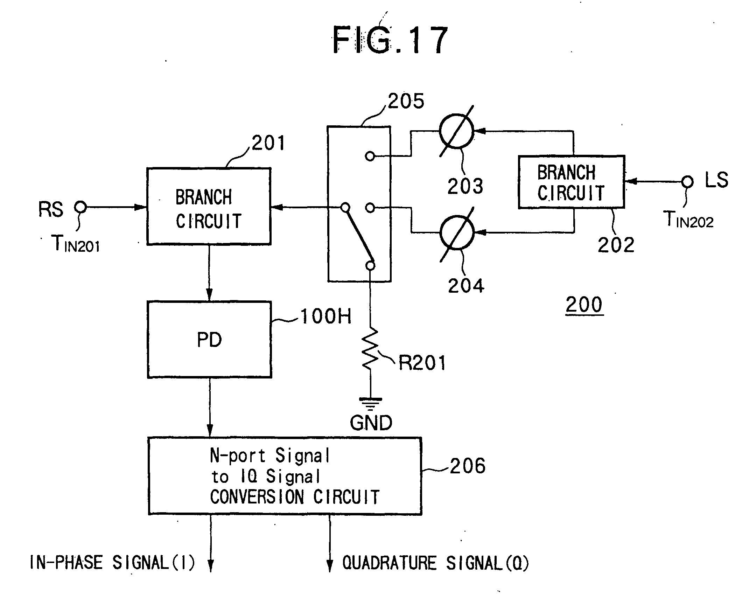

FIG. 17 is a circuit diagram showing a configuration example of a 3-port demodulator capable of applying a radio-frequency power detection circuit according to the present invention.

The 3-port demodulator 200 is configured by using one radio-frequency power detection circuit 100H, and further comprises a first signal input terminal TIN201 for a reception signal, a second signal input terminal TIN202 for a local signal, branch circuits 201 and 202, phase shifters 203 and 204, a switching circuit 205, and an N-port signal - IQ signal conversion circuit 206.

Here, the 3-port indicates three ports, that is, two ports of the first signal input terminal TIN201 for a reception signal and the second signal input terminal TIN202 for a local signal added with one port of an output terminal of the branch circuit 201 to the power detection circuit 100H.

Note that in the demodulator in FIG. 17, the branch circuits 201 and 202, phase shifters 203 and 204 and a switching circuit 205 compose a generation means.

In the 3-port demodulator 200, a reception signal RS input to the input terminal TIN201 is input to the branch circuit 201 and branched to two signals. One of the branched signals is input to the power detection circuit 100H.

Also, a local signal LS input to the input terminal TIN202 is input to the branch circuit 202 and branched to two signals. One of the branched signals is input to the phase shifter 203 and given a phase shift of θ, then, input to the switching circuit 205. The other branched signal is input to the phase shifter 204 and given a phase shift of an angle θ, then, input to the switching circuit 205. The signals given a phase shift effect by the phase shifter 203 and the phase shifter 204 are selectively switched by the switching circuit 205 in order and supplied to the branch circuit 201.

The signal input to the branch circuit 201 is branched to a signal to be input to the power detection circuit 100H and two signals to be supplied to the input terminal TIN201.

In the power detection circuit 100H, amplitude components of the input signal are detected and supplied to the conversion circuit 206. Then, in the conversion circuit 206, the input signals are converted to an inphase signal (I) and a quadrature signal (Q) as demodulation signals and output.

According to the present 3-port demodulator 200, since the power detection circuit 100H easily becomes wide-banded, it can be applied to a system required to have multi-band or wide band characteristics and respond to demands for radio-frequencies.

Also, since the power detection circuit 100H operates in a linear range, demodulation is possible even with a low local signal power and low-skew demodulation is possible.

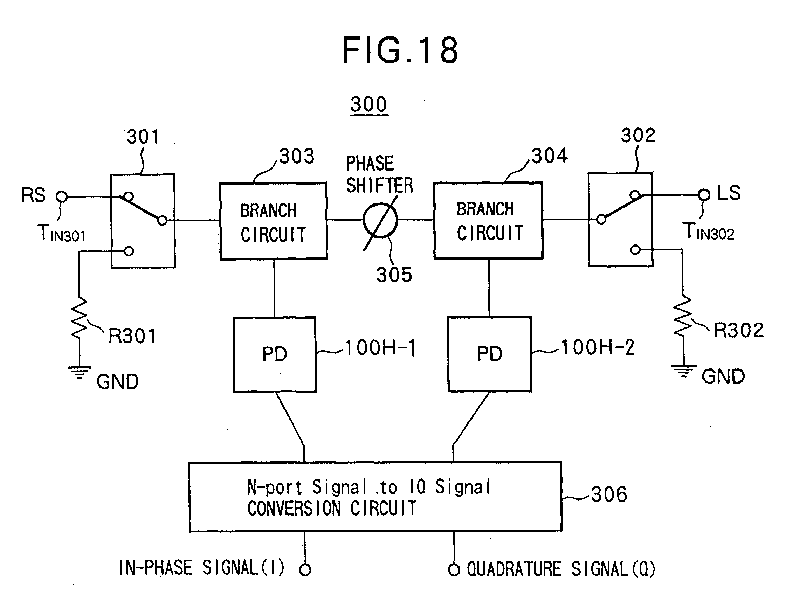

FIG. 18 is a circuit diagram showing a configuration example of time-sharing 4-port demodulator capable of applying a radio-frequency power detection circuit according to the present invention.

The 4-port demodulator 300 is configured by using two radio-frequency power detection circuits 100H-1 and 100H-2, and further comprises a reception signal input terminal IN301, a local signal input terminal TIN302, switching circuits 301 and 302, branch circuits 303 and 304, phase shifter 305 and an N-port signal - IQ signal conversion circuit 306.

Here, the 4-port means four ports, that is, two ports of the first input terminal TIN301 for a reception signal and a second input terminal TIN302 for a local signal added with two ports of an output terminal of the branch circuit 303 to the power detection circuit 100H-1 and an output terminal of the branch circuit 304 to the power detection circuit 100H-2.

Note that in the demodulator in FIG. 18, a generation means is configured by the switching circuits 301 and 302, branch circuits 303 and 304 and a phase shifter 305.

In the 4-port demodulator 300, the reception signal RS input to the input terminal TIN301 is input to the branch circuit 303 via the high speed switching circuit 301 and branched to two signals. One of the branched signals is input to the power detection circuit 100H-1 and the other signal is input to the phase shifter 305.

In the phase shifter 305, phase shift θ is given to the reception signal from the branch circuit 303, and the signal given with the phase shift effect is input to the branch circuit 304 and branched to two signals. In the branch circuit 304, one of the branched signals is input to the power detection circuit 100H-2 and the other signal is supplied to the high speed switching circuit 302.

Also, the local signal LS input to the input terminal TIN302 is input to the branch circuit 304 via the high speed switching circuit 302 and branched to two signals. One of the branched signals is input to the power detection circuit 100H-2 and the other signal is input to the phase shifter 305.

In the phase shifter 305, phase shift θ is given to the local signal from the branch circuit 304, and the signal given with the phase shift effect is input to the branch circuit 303 and branched to two signals. In the branch circuit 303, one of the branched signals is input to the power detection circuit 100H-1, and the other signal is supplied to the high speed switching circuit 301.

The power detection circuit 100H-1 is supplied with a reception signal and a local signal given with a phase shift θ. In the power detection circuit 100H-1, amplitude components of the supplied signals are detected and supplied to the conversion circuit 306.

Also, the power detection circuit 100H-2 is supplied with a local signal and a reception signal given with phase shift θ. In the power detection circuit 100H-2, amplitude components of the supplied signals are detected and supplied to the conversion circuit 306.

In the conversion circuit 306, the input signal is converted to an inphase signal (I) and a quadrature signal (Q) and output.

According to the 4-port demodulator, the same effects as in the 3-port demodulator explained above can be obtained.

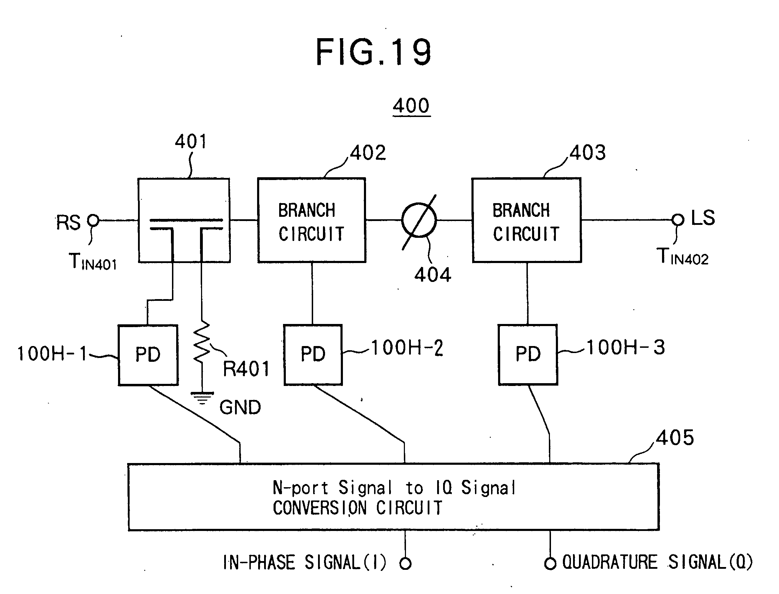

FIG. 19 is a circuit diagram showing a configuration example of a 5-port demodulator capable of applying the radio-frequency power detection circuit of the present invention.

The 5-port demodulator 400 is configured by three radio-frequency power detection circuits 100H-1, 100H-2 and 100H-3, and furthermore comprises a first signal input terminal TIN401 for a reception signal, a second signal input terminal TIN402 for a local signal, a coupler 401, branch circuits 402 and 403, a phase shifter 404 and an N-port signal - IQ signal conversion circuit 405.

Here, the 5-port means five ports, that is, two ports of the reception signal input terminal TIN401, the local signal input terminal TIN402 added with three ports of an output terminal of the coupler 401 to the power detection circuit 100H-1, an output terminal of the branch circuit 402 to the power detection circuit 100H-2, and an output terminal of the branch circuit 403 to the power detection circuit 100H-3.

Note that in the demodulator in FIG. 19, a generation means is configured by the coupler 401, the branch circuits 402 and 403 and the phase shifter 404.

In the 5-port demodulator 400, a reception signal RS input to the input terminal TIN401 is input to the branch circuit 402 by the coupler 401, and a part thereof is input to the power detection circuit 100H-1.

The reception signal input to the branch circuit 402 is branched to two signals. One of the branched signals is input to the power detection circuit 100H-2, and the other signal is input to the phase shifter 404.

In the phase shifter 404, phase shift θ is given to the reception signal from the branch circuit 402, the signal given with the phase shift effect is input to the branch circuit 403 and branched to two signals. In the branch circuit 403, one of the branched signals is input to the power detection circuit 100H-3 and the other signal is supplied to the input terminal TIN402.

Also, the local signal LS input to the input terminal TIN402 is input to the branch circuit 403 and branched to two signals. One of the branched signals is input to the power detection circuit 100H-3 and the other signal is input to the phase shifter 404.

In the phase shifter 404, phase shift θ is given to the local signal from the branch circuit 403, and the signal given with the phase shift effect is input to the branch circuit 402 and branched to two signals. In the branch circuit 402, one of the branched signals is input to the power detection circuit 100H-2 and the other signal is supplied to the coupler 401.

The power detection circuit 100H-1 is supplied with a reception signal. In the power detection circuit 100H-1, amplitude components of the supplied signal are detected and supplied to the conversion circuit 405.

The power detection circuit 100H-2 is supplied with a reception signal and a local signal given with phase shift θ. In the power detection circuit 100H-2, amplitude components of the supplied signal are detected and supplied to the conversion circuit 405.

Also, the power detection circuit 100H-3 is supplied with a local signal and a reception signal given with phase shift θ. In the power detection circuit 100H-3, amplitude components of the supplied signal are detected and supplied to the conversion circuit 405.

In the conversion circuit 405, the input signal is converted to an inphase signal (I) and a quadrature signal (Q) and output.

According to the 5-port demodulator, the same effects as in the 3-port demodulator explained above can be obtained.

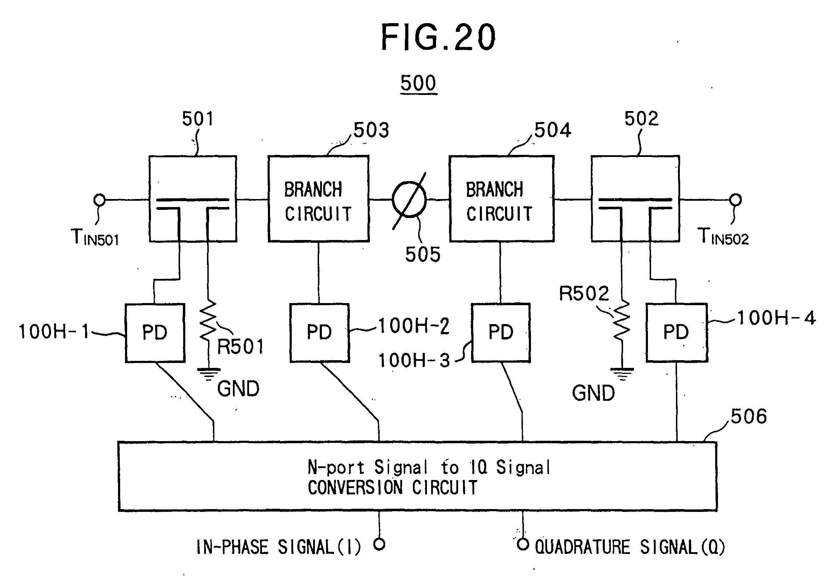

FIG. 20 is a circuit diagram of a configuration example of 6-port demodulator capable of applying the radio-frequency power detection circuit according to the present invention.

The 6-port demodulator 500 is configured by four power detection circuits 100H-1, 100H-2, 100H-3 and 100H-4, and furthermore comprises a first signal input terminal TIN501 for a reception signal, a second signal input terminal TIN502 for a local signal, couplers 501 and 502, branch circuits 503 and 504, a phase shifter 505 and an N-port signal - IQ signal conversion circuit 506.

Here, the 6-port means six ports, that is, two ports of the reception signal input terminal TIN501 and the local signal input terminal TIN502, added with four ports of an output terminal of the coupler 401 to the power detection circuit 100H-1, an output terminal of the branch circuit 402 to the power detection circuit 100H-2, an output terminal of the branch circuit 403 to the power detection circuit 100H-3, and an output terminal of the coupler 402 to the power detection circuit 100H-4.

Note that in the demodulator in FIG. 20, a generation means is configured by the couplers 501 and 502, branch circuits 503 and 504, and a phase shifter 505.

In the 6-port demodulator 500, a reception signal RS input to the input terminal TIN501 is input to the branch circuit 503 by the coupler 501, and a part thereof is input to the power detection circuit 100H-1.

The reception signal input to the branch circuit 503 is branched to two signals. One of the branched signals is input to the power detection circuit 100H-2 and the other signal is input to the phase shifter 505.

In the phase shifter 505, phase shift θ is given to the reception signal from the branch circuit 503, the signal given with the phase shift effect is input to the branch circuit 504 and branched to two signals. In the branch circuit 504, one of the branched signals is input to the power detection circuit 100H-3 and the other signal is input to the coupler 502.

In the coupler 502, the input signal is supplied to the input terminal TIN502 by the coupler 501.

Also, a local signal LS input to the input terminal TIN502 is input to the branch circuit 504 by the coupler 502, and a part thereof is input to the power detection circuit 100H-4.

The local signal input to the branch circuit 504 is branched to two signals. One of the branched signals is input to the power detection circuit 100H-3 and the other signal is input to the phase shifter 504.

In the phase shifter 504, phase shift θ is given to the local signal from the branch circuit 504, and the signal given with the phase shift effect is input to the branch circuit 503 and branched to two signals. In the branch circuit 503, one of the branched signals is input to the power detection circuit 100H-2 and the other signal is supplied to the coupler 501.

The power detection circuit 100H-1 is supplied only with the reception signal. In the power detection circuit 100H-1, amplitude components of the supplied reception signal are detected and supplied to the conversion circuit 506.

The power detection circuit 100H-2 is supplied with a reception signal and a local signal given with phase shift θ. In the power detection circuit 100H-2, amplitude components of the supplied signal are detected and supplied to the conversion circuit 506.

Also, the power detection circuit 100H-3 is supplied with a local signal and a reception signal given with phase shift θ. In the power detection circuit 100H-3, amplitude components of the supplied signal are detected and supplied to the conversion circuit 506.

Also, the power detection circuit 100H-4 is supplied only with a local signal. In the power detection circuit 100H-4, amplitude components of the supplied signal are detected and supplied to the conversion circuit 506.

In the conversion circuit 505, the input signal is converted to an inphase signal (I) and a quadrature signal (Q) as demodulation signals and output.

According to the 6-port demodulator, the same effects as in the 3-port demodulator explained above can be obtained.

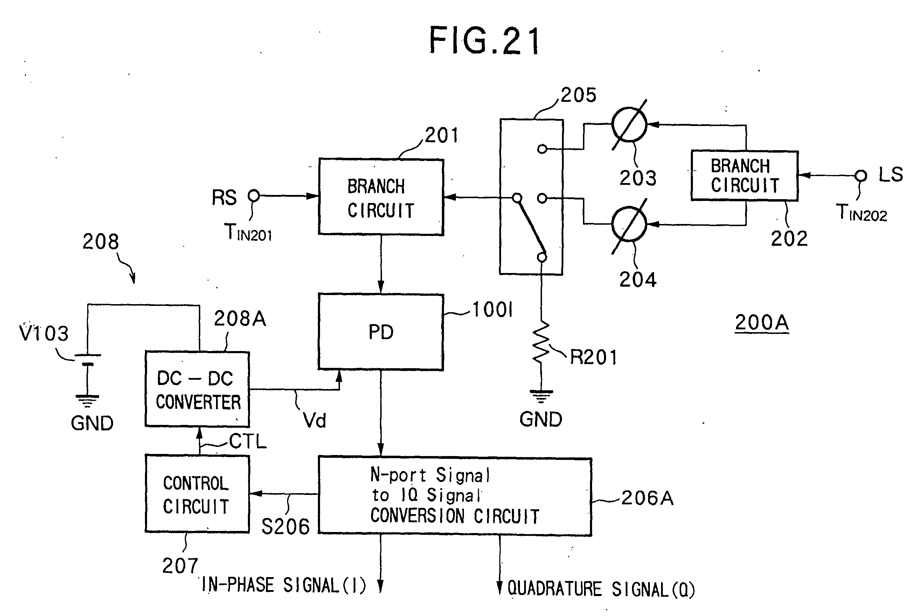

FIG. 21 is a circuit diagram showing another configuration example of 3-port demodulator capable of applying the radio-frequency power detection circuit according to the present invention.

A different point in the 3-port demodulator 200A in FIG. 21 from the demodulator 200 in FIG. 17 is that drain bias voltages of transistors Q101 and Q102 of a power detection circuit 100I are changed in accordance with reception signal level information, specifically, it is controlled by a control circuit 207 to set the drain bias voltages low when the reception signal level is lower than a predetermined level.

Note that the power detection circuit 100I is a power detection circuit (PD) indicated by the reference number 100I indicating to include any one of the circuits instead of the eight reference numbers 100 and 100A to 100G according to the first to eight embodiments explained above. Note that the power detection circuit 100I is a circuit equivalent to a circuit (not including the voltage source V103), wherein the voltage source V103 composing the drain bias supply circuit in the eight circuits 100 and 100A to 100G according to the first to eight embodiments is taken out as a circuit 208.

A conversion circuit 206A of the 3-port demodulator 200A in FIG. 21 has a function as a level detection circuit for detecting a reception signal level and supplying the same as a reception signal level signal S206 to a control circuit 207 in addition to a function of converting an input signal to an inphase signal (I) and a quadrature signal (Q) as demodulation signals based on amplitude components of the input signal detected in the power detection circuit 100I.

As explained above, the drain bias supply circuit 208 taken out from the power detection circuit 100I has, for example, on the output side of the voltage source V103 of 3V a DC-DC converter 208A for changing a drain bias voltage Vd in accordance with a control signal CTL of the control circuit 207. An output voltage of the DC-DC converter 208A is supplied to drains of the transistors Q101 and Q102 via resistor elements R104 and R105 in the eight circuits 100 to 100A to 100G according to the first to eight embodiments.

The control circuit 207 receives a reception signal level signal S206 from the conversion circuit 206A and outputs a control signal CTL to the DC-DC converter 208A to supply the drain bias voltage Vd in accordance with the reception signal level.

Specifically, when the reception signal level (power) is -10 dBm to -5 dBm, the control circuit 207 generates a control signal CTL to supply as it is as 3V, when the reception signal level (power) is -25 dBm to -15 dBm, generates a control signal CTL to lower to 2V to supply, when the reception signal level (power) is -100 dBm to -25 dBm, generates a control signal CTL to lower to 1V to supply and outputs to the DC-DC converter.

Namely, the control circuit 207 generates a control signal CTL to lower the supply voltage of the voltage source 103 by 30% to 70% in accordance with the reception signal level.

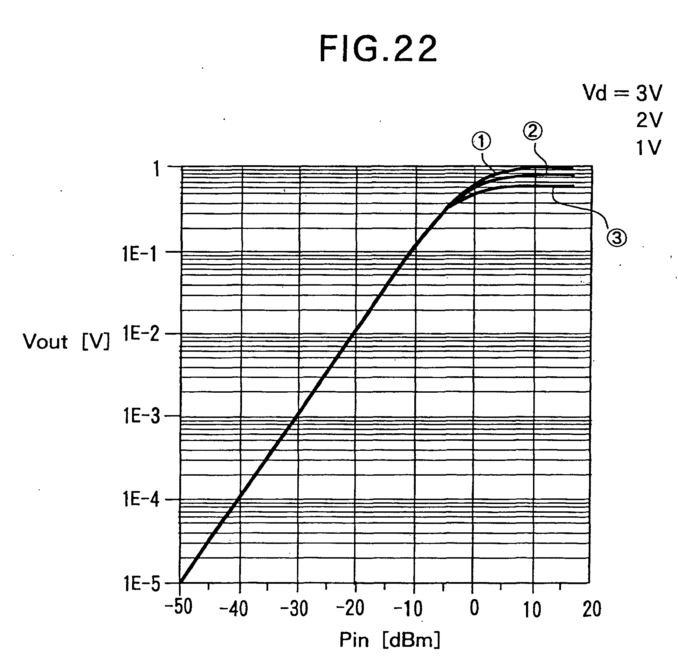

FIG. 22 is a view showing input power dependency of an output detection voltage of the radio-frequency power detection circuit when changing the drain bias voltage in accordance with reception signal level information.

In FIG. 22, an abscissa indicates input radio-frequency power Pin and an ordinate indicates an output detection voltage Vout. A frequency of the input radio-frequency signal is 5.5 GHz. In FIG. 22, characteristics of the power detection circuit when the drain bias voltage Vd is 3V is shown by a curve (1), characteristics of the power detection circuit when the drain bias voltage Vd is 2V is shown by a curve (2), and characteristics of the power detection circuit when the drain bias voltage Vd is 1V is shown by a curve (3).

As is known from FIG. 22, when the reception signal level is low, linearity is maintained even when the drain bias voltage is lowered.

Accordingly, according to the demodulator 200A in FIG. 21, the power detection circuit 100I easily becomes wide-banded, so that it can be applied to a system required to have multi-band or wide-band characteristics, respond to demands for higher frequencies. Furthermore, since the power detection circuit 100I operates in a linear range, there are advantages that demodulation with low local signal power is possible, low-skew demodulation is possible, and power saving is attained when the reception signal level is low.

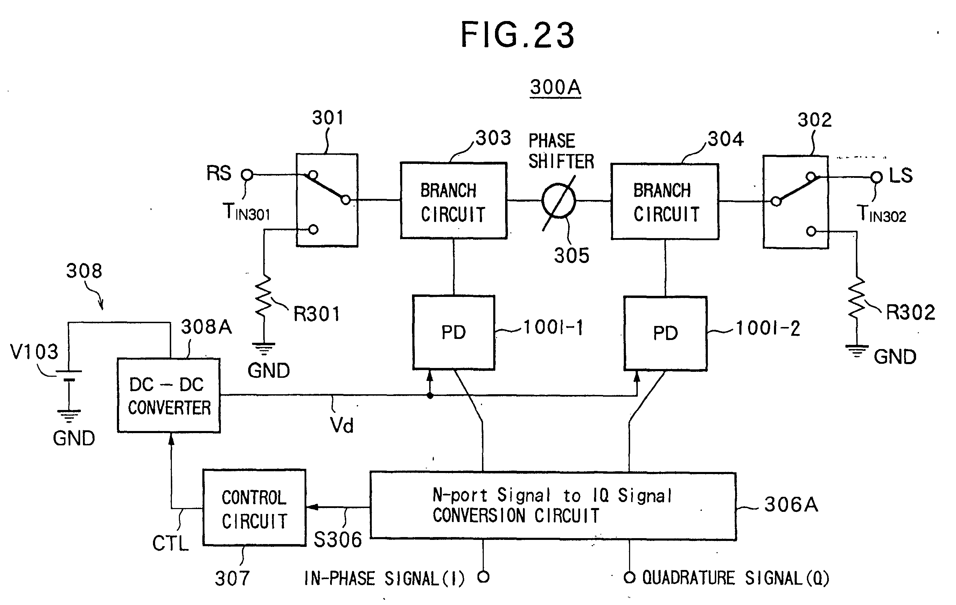

FIG. 23 is a circuit diagram showing another configuration example of a 4-port demodulator capable of applying the radio-frequency power detection circuit according to the present invention.

A different point in a 4-port demodulator 300A in FIG. 23 from the demodulator 300 in FIG. 18 is that drain bias voltages of the transistors Q101 and Q102 of the power detection circuits 100I-1 and 100I-2 are changed in accordance with reception signal level information, specifically, it is controlled by a control circuit 307 to set the drain bias voltages low when the reception signal level is lower than a predetermined level.

Note that the power detection circuits 100I-1 and 100I-2 indicate a radio-frequency power detection circuit (PD) indicated by the reference number 100I indicating to include any one of the circuits instead of the eight reference numbers 100 and 100A to 100G according to the first to eight embodiments explained above. Note that the power detection circuit 100I is a circuit equivalent to a circuit (not including the voltage source V103), wherein the voltage source V103 composing the drain bias supply circuit in the eight circuits 100 and 100A to 100G according to the first to eight embodiments is taken out as a circuit 308. The drain bias circuit 308 is shared by the power detection circuits 100I-1 and 100I-2.

A conversion circuit 306A of the 4-port demodulator 300A in FIG. 23 has a function as a level detection circuit for detecting a reception signal level and supplying the same as a reception signal level signal S306 to a control circuit 307 in addition to a function of converting an input signal to an inphase signal (I) and a quadrature signal (Q) as demodulation signals based on amplitude components of the input signal detected in the power detection circuits 100I-1 and 100I-2.

As explained above, the drain bias supply circuit 308 taken out from the power detection circuits 100I-1 and 100I-2 to be shared has, for example, on the output side of the voltage source V103 of 3V a DC-DC converter 308A for changing a drain bias voltage Vd in accordance with a control signal CTL of the control circuit 307. An output voltage of the DC-DC converter 308A is supplied to drains of the transistors Q101 and Q102 via resistor elements R104 and R105 in the eight circuits 100 to 100A to 100G according to the first to eight embodiments.

The control circuit 307 receives a reception signal level signal S306 from the conversion circuit 306A and outputs a control signal CTL to the DC-DC converter 308A to supply the drain bias voltage Vd in accordance with the reception signal level.

Specifically, when the reception signal level (power) is -10 dBm to -5 dBm, the control circuit 307 generates a control signal CTL to supply as it is as 3V, when the reception signal level (power) is -25 dBm to -15 dBm, generates a control signal CTL to lower to 2V to supply, when the reception signal level (power) is -100 dBm to -25 dBm, generates a control signal CTL to lower to 1V to supply and outputs to the DC-DC converter.

Namely, the control circuit 307 generates a control signal CTL to lower the supply voltage of the voltage source 103 by 30% to 70% in accordance with the reception signal level.

Input power dependency of an output detection voltage of the radio-frequency power detection circuits 100H-1 and 100I-2 applied to the demodulator 300A in FIG. 23 can obtain the same characteristic as that in FIG. 22.

Namely, the radio-frequency power detection circuits 100I-1 and 100I-2 maintain linearity even when the reception signal level is low or the drain bias voltage is lowered.

Accordingly, according to the demodulator 300A in FIG. 23, the power detection circuits 100I-1 and 100I-2 easily become wide-banded, so that they can be applied to a system required to have multi-band or wide-band characteristics, respond to demands for higher frequencies. Furthermore, since the power detection circuits 100I-1 and 100I-2 operate in a linear range, there are advantages that demodulation with low local signal power is possible, low-skew demodulation is possible, and power saving is attained when the reception signal level is low.

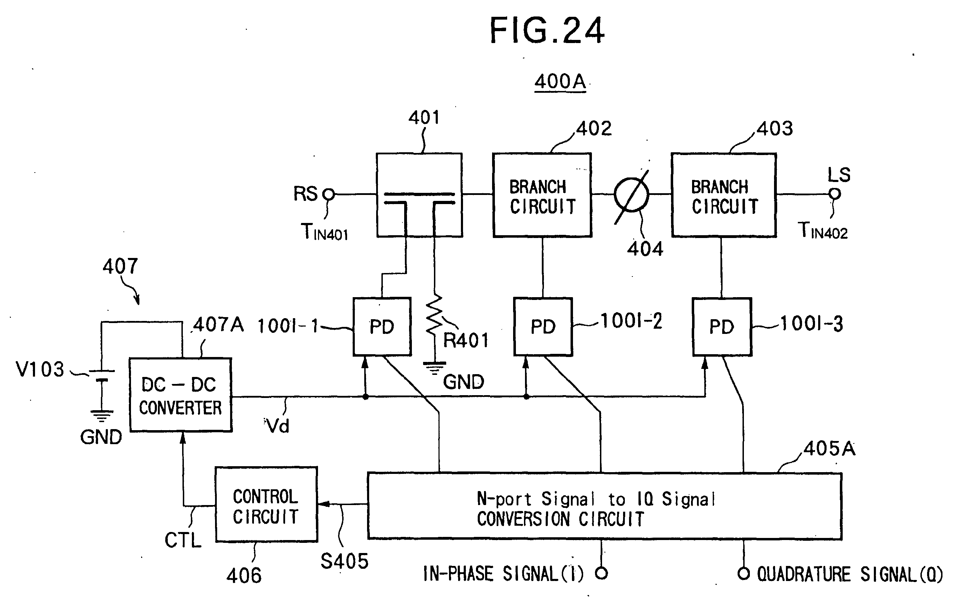

FIG. 24 is a circuit diagram showing another configuration example of a 5-port demodulator capable of applying the radio-frequency power detection circuit according to the present invention.

A different point in a 5-port demodulator 400A in FIG. 24 from the demodulator 400 in FIG. 19 is that drain bias voltages of the transistors Q101 and Q102 of the power detection circuits 100I-1, 100I-2 and 100I-3 are changed in accordance with reception signal level information, specifically, it is controlled by a control circuit 406 to set the drain bias voltages low when the reception signal level is lower than a predetermined level.

Note that the power detection circuits 100I-1 to 100I-3 indicate a radio-frequency power detection circuit (PD) indicated by the reference number 100I indicating to include any one of the circuits instead of the eight reference numbers 100 and 100A to 100G according to the first to eight embodiments explained above. Note that the power detection circuit 100I is a circuit equivalent to a circuit (not including the voltage source V103), wherein the voltage source V103 composing the drain bias supply circuit in the eight circuits 100 and 100A to 100G according to the first to eight embodiments is taken out as a circuit 407. The drain bias supply circuit 407 is shared by the power detection circuits 100I-1 and 100I-2.

A conversion circuit 405A of the 5-port demodulator 400A in FIG. 24 has a function as a level detection circuit for detecting a reception signal level and supplying the same as a reception signal level signal S405 to a control circuit 406 in addition to a function of converting an input signal to an inphase signal (I) and a quadrature signal (Q) as demodulation signals based on amplitude components of the input signal detected in the power detection circuits 100I-1 to 100I-3.

As explained above, the drain bias supply circuit 407 taken out from the power detection circuits 100I-1 to 100I-3 to be shared has, for example, on the output side of the voltage source V103 of 3V a DC-DC converter 407A for changing a drain bias voltage Vd in accordance with a control signal CTL of the control circuit 406. An output voltage of the DC-DC converter 407A is supplied to drains of the transistors Q101 and Q102 via resistor elements R104 and R105 in the eight circuits 100 to 100A to 100G according to the first to eight embodiments.

The control circuit 406 receives a reception signal level signal S405 from the conversion circuit 405A and outputs a control signal CTL to the DC-DC converter 407A to supply the drain bias voltage Vd in accordance with the reception signal level.

Specifically, when the reception signal level (power) is -10 dBm to -5 dBm, the control circuit 406 generates a control signal CTL to supply as it is as 3V, when the reception signal level (power) is -25 dBm to -15 dBm, generates a control signal CTL to lower to 2V to supply, when the reception signal level (power) is -100 dBm to -25 dBm, generates a control signal CTL to lower to 1V to supply and outputs to the DC-DC converter.

Namely, the control circuit 406 generates a control signal CTL to lower the supply voltage of the voltage source 103 by 30% to 70% in accordance with the reception signal level.

Input power dependency of an output detection voltage of the radio-frequency power detection circuits 100H-1 to 100I-3 applied to the demodulator 400A in FIG. 24 can obtain the same characteristic as that in FIG. 22.

Namely, the radio-frequency power detection circuits 100I-1 to 100I-3 maintain linearity even when the reception signal level is low or the drain bias voltage is lowered.

Accordingly, according to the demodulator 400A in FIG. 24, the power detection circuits 100I-1 to 100I-3 easily become wide-banded, so that they can be applied to a system required to have multi-band or wide-band characteristics, respond to demands for higher frequencies. Furthermore, since the power detection circuits 100I-1 to 100I-3 operate in a linear range, there are advantages that demodulation with low local signal power is possible, low-skew demodulation is possible, and power saving is attained when the reception signal level is low.

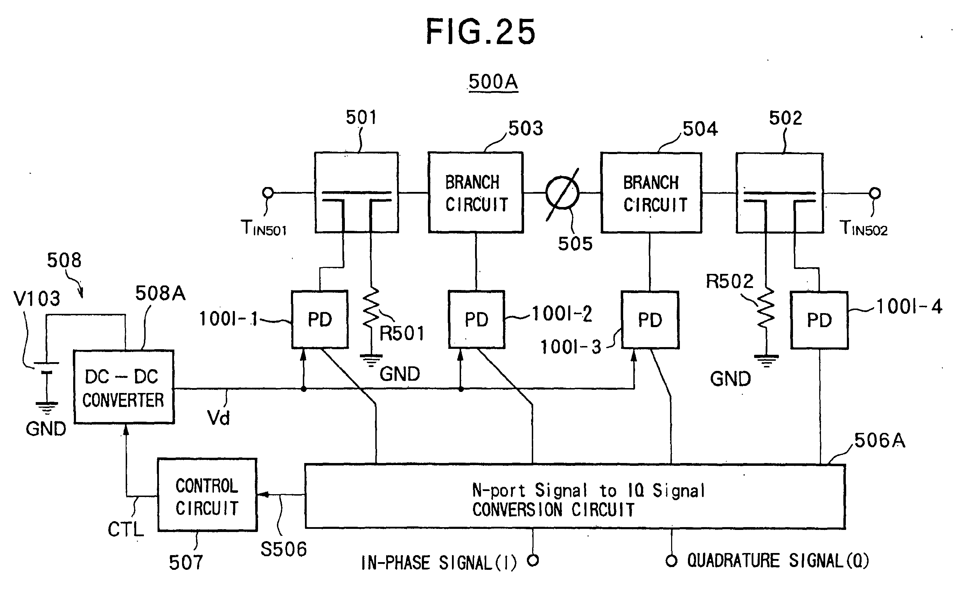

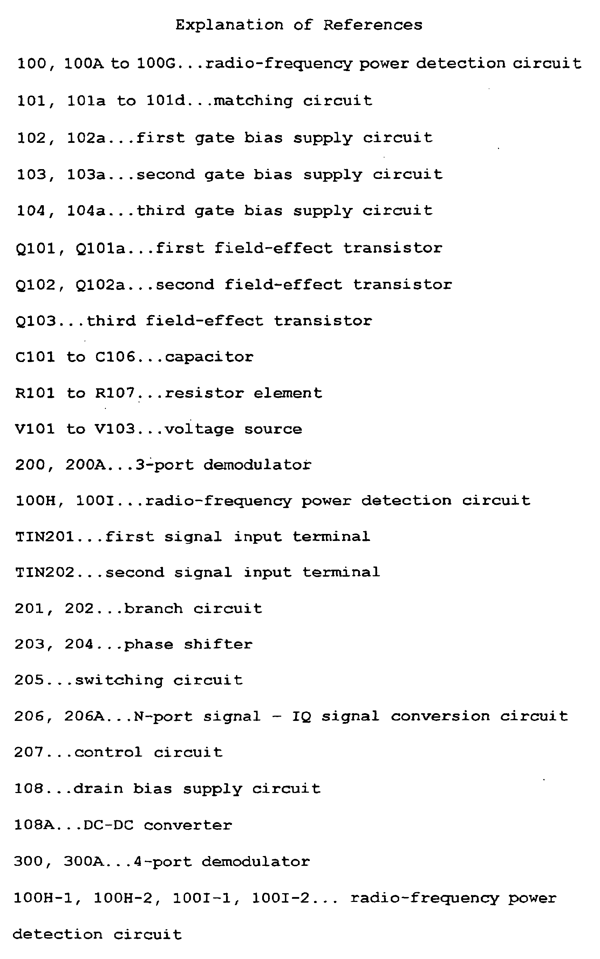

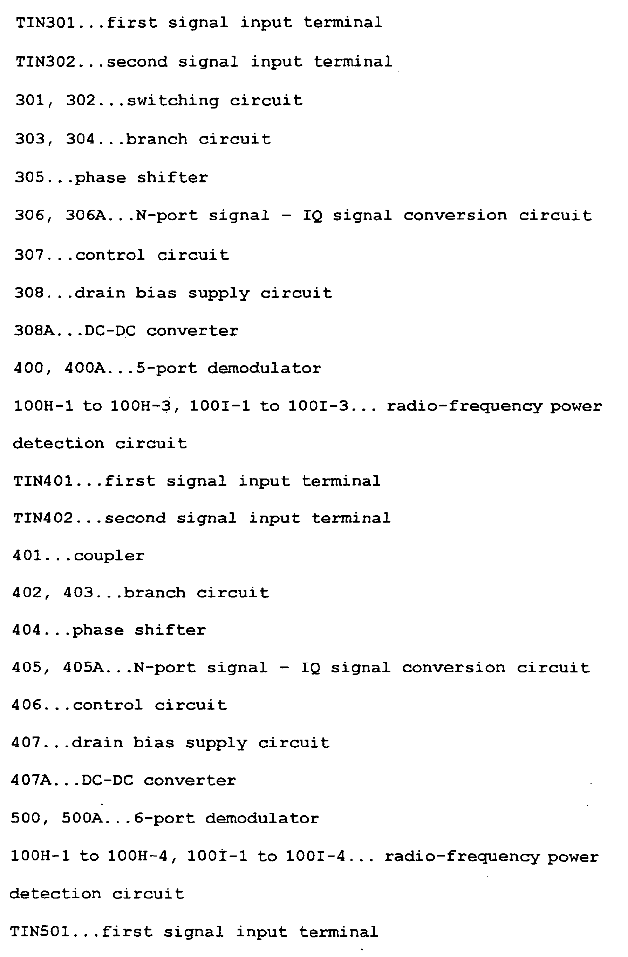

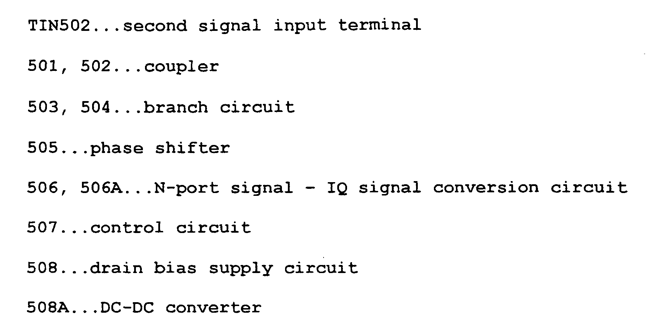

FIG. 25 is a circuit diagram showing another configuration example of a 6-port demodulator capable of applying the radio-frequency power detection circuit according to the present invention.

A different point in a 6-port demodulator 500A in FIG. 25 from the demodulator 500 in FIG. 20 is that drain bias voltages of the transistors Q101 and Q102 of the power detection circuits 100I-1, 100I-2, 100I-3 and 100I-4 are changed in accordance with reception signal level information, specifically, it is controlled by a control circuit 507 to set the drain bias voltages low when the reception signal level is lower than a predetermined level.

Note that the power detection circuits 100I-1 to 100I-4 indicate a radio-frequency power detection circuit (PD) indicated by the reference number 100I indicating to include any one of the circuits instead of the eight reference numbers 100 and 100A to 100G according to the first to eight embodiments explained above. Note that the power detection circuit 100I is a circuit equivalent to a circuit (not including the voltage source V103), wherein the voltage source V103 composing the drain bias supply circuit in the eight circuits 100 and 100A to 100G according to the first to eight embodiments is taken out as a circuit 508. The drain bias circuit 508 is shared by the power detection circuits 100I-1 to 100I-4.

A conversion circuit 506A of the 5-port demodulator 500A in FIG. 25 has a function as a level detection circuit for detecting a reception signal level and supplying the same as a reception signal level signal S506 to a control circuit 507 in addition to a function of converting an input signal to an inphase signal (I) and a quadrature signal (Q) as demodulation signals based on amplitude components of the input signal detected in the power detection circuits 100I-1 to 100I-4.

As explained above, the drain bias supply circuit 508 taken out from the power detection circuits 100I-1 to 100I-4 to be shared has, for example, on the output side of the voltage source V103 of 3V a DC-DC converter 508A for changing a drain bias voltage Vd in accordance with a control signal CTL of the control circuit 507. An output voltage of the DC-DC converter 508A is supplied to drains of the transistors Q101 and Q102 via resistor elements R104 and R105 in the eight circuits 100 to 100A to 100G according to the first to eight embodiments.

The control circuit 507 receives a reception signal level signal S506 from the conversion circuit 506A and outputs a control signal CTL to the DC-DC converter 508A to supply the drain bias voltage Vd in accordance with the reception signal level.

Specifically, when the reception signal level (power) is -10 dBm to -5 dBm, the control circuit 507 generates a control signal CTL to supply as it is as 3V, when the reception signal level (power) is -25 dBm to -15 dBm, generates a control signal CTL to lower to 2V to supply, when the reception signal level (power) is -100 dBm to -25 dBm, generates a control signal CTL to lower to 1V to supply and outputs to the DC-DC converter.

Namely, the control circuit 507 generates a control signal CTL to lower the supply voltage of the voltage source 103 by 30% to 70% in accordance with the reception signal level.

The input power dependency of an output detection voltage of the radio-frequency power detection circuits 100H-1 to 100I-4 applied to the demodulator 500A in FIG. 25 can obtain the same characteristic as that in FIG. 22.

Namely, the radio-frequency power detection circuits 100I-1 to 100I-4 maintain linearity even when the reception signal level is low or the drain bias voltage is lowered.

Accordingly, according to the demodulator 500A in FIG. 25, the power detection circuits 100I-1 to 100I-4 easily become wide-banded, so that they can be applied to a system required to have multi-band or wide-band characteristics, respond to demands for higher frequencies. Furthermore, since the power detection circuits 100I-1 to 100I-4 operate in a linear range, there are advantages that demodulation with low local signal power is possible, low-skew demodulation is possible, and power saving is attained when the reception signal level is low.

### Industrial Applicability

As explained above, according to a power detection circuit according to the present invention and a demodulator using the same, comparing with a detection circuit using a silicon Schottky diode, since it can be configured on a semiconductor process suitable to radio-frequencies, such as GaAs, it is suitable to be made monolithic. Accordingly, a compact detection circuit being wide-banded and suitable to a radio-frequency operation can be realized at low costs. Also, the power detection circuit of the present invention can realize a high performance radio-frequency power detection circuit having excellent linearity in detection characteristics, small fluctuation in detection characteristics against bias fluctuation, small fluctuation in detection characteristics against FET threshold voltage fluctuation, and small DC offset. Also, the power detection circuit of the present invention has a balanced output, so that when a subsequent circuit has a balanced input, the connection becomes easy.

## Claims

1. A power detection circuit for detecting a signal level of a radio-frequency signal, comprising:
a first field-effect transistor having a gate supplied with said radio-frequency signal;
a second field-effect transistor having a source connected to a source of said first field-effect transistor;
a first gate bias supply circuit for supplying a gate bias voltage to a gate of said first field-effect transistor;
a second gate bias supply circuit for supplying a gate bias voltage to a gate of said second field-effect transistor;
a current source connected between a connection point of sources of said first field-effect transistor and second field-effect transistor and a reference potential;
a first capacitor connected in parallel with said current source between a connection point of sources of said first field-effect transistor and second field-effect transistor and a reference potential;
a drain bias supply circuit for supplying a drain bias voltage to drains of said first field-effect transistor and second field-effect transistor;
a second capacitor connected between a drain of said first field-effect transistor and a reference potential; and
a third capacitor connected between a drain of said second field-effect transistor and a reference potential,
wherein a voltage difference between a drain voltage of said first field-effect transistor and a drain voltage of said second field-effect transistor is defined as a detection output.

2. A power detection circuit as set forth in claim 1, wherein:
said first field-effect transistor and said second field-effect transistor have approximately the same characteristics;
said drain bias supply circuit includes a first drain bias resistor element connected between a drain of said first field-effect transistor and a voltage source, and a second drain bias resistor element connected between a drain of said second field-effect transistor and a voltage source;
a resistance value of said first drain bias resistor element and a resistance value of said second drain bias resistor element are set to be approximately same values; and
a capacitance value of said second capacitor and a capacitance value of said third capacitor are set to be approximately the same values.

3. A power detection circuit as set forth in claim 1, wherein:
a ratio Wga/Wgb of a gate width Wga of said first field-effect transistor and a gate width Wgb of said second field-effect transistor is set to be N;
said drain bias supply circuit includes a first drain bias resistor element connected between a drain of said first field-effect transistor and a voltage source, and a second drain bias resistor element connected between a drain of said second field-effect transistor and a voltage source;
a first gate bias voltage by said first gate bias supply circuit and a second gate bias voltage by said second gate bias supply circuit are set to be the approximately same;
a resistance value Ra of said first drain bias resistor element and a resistance value Rb of said second drain bias resistor element are set to satisfy a condition of Ra/Rb = 1/N; and
a capacitance value of said second capacitor and a capacitance value of said third capacitor are set to be approximately same values.

4. A power detection circuit as set froth in claim 1, wherein said current source includes a resistor element.

5. A power detection circuit as set forth in claim 1, wherein said current source comprises
a third field-effect transistor connected between a connection point of sources of said first field-effect transistor and said second field-effect transistor and a reference potential, and
a third gate bias supply circuit for supplying a gate bias voltage to a gate of said third field-effect transistor.

6. A power detection circuit for detecting a signal level of a radio-frequency signal, comprising:
a first field-effect transistor having a gate supplied with said radio-frequency signal;
a second field-effect transistor having a source connected to a source of said first field-effect transistor;
a first gate bias supply circuit for supplying a gate bias voltage to a gate of said first field-effect transistor;
a second gate bias supply circuit for supplying a gate bias voltage to a gate of said second field-effect transistor;
a current source connected between a connection point of sources of said first field-effect transistor and second field-effect transistor and a reference potential;
a first capacitor connected in parallel with said current source between a connection point of sources of said first field-effect transistor and second e-f transistor and a reference potential;
a drain bias supply circuit for supplying a drain bias voltage to drains of said first field-effect transistor and second field-effect transistor; and
a second capacitor connected between a drain of said first field-effect transistor and a drain of said second field-effect transistor,
wherein a voltage difference between a drain voltage of said first field-effect transistor and a drain voltage of said second field-effect transistor is defined as a detection output.

7. A power detection circuit as set forth in claim 6, wherein:
said first field-effect transistor and said second field-effect transistor have approximately same characteristics;
said drain bias supply circuit includes a first drain bias resistor element connected between a drain of said first field-effect transistor and a voltage source, and a second drain bias resistor element connected between a drain of said second field-effect transistor and a voltage source; and
a resistance value of said first drain bias resistance element and a resistance value of said second drain bias resistor element are set to be approximately same values.

8. A power detection circuit as set froth in claim 6, wherein:
a ratio Wga/Wgb of a gate width Wga of said first field-effect transistor and a gate width Wgb of said second field-effect transistor is set to be N;
said drain bias supply circuit includes a first drain bias resistor element connected between a drain of said first field-effect transistor and a voltage source, and a second drain bias resistor element connected between a drain of said second field-effect transistor and a voltage source;
a first gate bias voltage by said first gate bias supply circuit and a second gate bias voltage by said second gate bias supply circuit are set to be the approximately same; and
a resistance value Ra of said first drain bias resistor element and a resistance value Rb of said second drain bias resistor element are set to satisfy a condition of Ra/Rb = 1/N.

9. A power detection circuit as set forth in claim 6, wherein said current source includes a resistor element.

10. A power detection circuit as set forth in claim 6, wherein said current source comprises
a third field-effect transistor connected between a connection point of sources of said first field-effect transistor and said second field-effect transistor and a reference potential, and
a third gate bias supply circuit for supplying a gate bias voltage to a gate of said third field-effect transistor.

11. A power detection circuit for detecting a signal level of a radio-frequency signal, comprising:
a first field-effect transistor having a gate supplied with said radio-frequency signal;
a second field-effect transistor having a gate supplied with said radio-frequency signal and a source connected to a source of said first field-effect transistor;
a first gate bias supply circuit for supplying a gate bias voltage to a gate of said first field-effect transistor;
a second gate bias supply circuit for supplying a gate bias voltage to a gate of said second field-effect transistor;
a current source connected between a connection point of sources of said first field-effect transistor and second field-effect transistor and a reference potential;
a first capacitor connected in parallel with said current source between a connection point of sources of said first field-effect transistor and second e-f transistor and a reference potential;
a drain bias supply circuit for supplying a drain bias voltage to drains of said first field-effect transistor and second field-effect transistor;
a second capacitor connected between a drain of said first field-effect transistor and a reference potential; and
a third capacitor connected between a drain of said second field-effect transistor and a reference potential;
wherein a voltage difference between a drain voltage of said first field-effect transistor and a drain voltage of said second field-effect transistor is regarded as a detection output.

12. A power detection circuit as set forth in claim 11, wherein:
said first field-effect transistor and said second field-effect transistor have approximately same characteristics;
said drain bias supply circuit includes a first drain bias resistor element connected between a drain of said first field-effect transistor and a voltage source, and a second drain bias resistor element connected between a drain of said second field-effect transistor and a voltage source;
a resistance value of said first drain bias resistance element and a resistance value of said second drain bias resistor element are set to be approximately same values; and
a capacitance value of said second capacitor and a capacitance value of said third capacitor are set to be approximately the same values.

13. A power detection circuit as set froth in claim 11, wherein:
a ratio Wga/Wgb of a gate width Wga of said first field-effect transistor and a gate width Wgb of said second field-effect transistor is set to be N;
said drain bias supply circuit includes a first drain bias resistor element connected between a drain of said first field-effect transistor and a voltage source, and a second drain bias resistor element connected between a drain of said second field-effect transistor and a voltage source;
a first gate bias voltage by said first gate bias supply circuit and a second gate bias voltage by said second gate bias supply circuit are set to be the approximately same;
a resistance value Ra of said first drain bias resistor element and a resistance value Rb of said second drain bias resistor element are set to satisfy a condition of Ra/Rb = 1/N; and
a capacitance value of said second capacitor and a capacitance value of said third capacitor are set to be approximately the same values.

14. A power detection circuit as set forth in claim 11, wherein said current source includes a resistor element.

15. A power detection circuit as set forth in claim 11, wherein said current source comprises
a third field-effect transistor connected between a connection point of sources of said first field-effect transistor and said second field-effect transistor and a reference potential, and
a third gate bias supply circuit for supplying a gate bias voltage to a gate of said third field-effect transistor.

16. A power detection circuit for detecting a signal level of a radio-frequency signal, comprising:
a first field-effect transistor having a gate supplied with said radio-frequency signal;
a second field-effect transistor having a gate supplied with said radio-frequency signal and a source connected to a source of said first field-effect transistor;
a first gate bias supply circuit for supplying a gate bias voltage to a gate of said first field-effect transistor;
a second gate bias supply circuit for supplying a gate bias voltage to a gate of said second field-effect transistor;
a current source connected between a connection point of sources of said first field-effect transistor and second field-effect transistor and a reference potential;
a first capacitor connected in parallel with said current source between a connection point of sources of said first field-effect transistor and second e-f transistor and a reference potential;
a drain bias supply circuit for supplying a drain bias voltage to drains of said first field-effect transistor and second field-effect transistor; and
a second capacitor connected between a drain of said first field-effect transistor and a drain of said second field-effect transistor;
wherein a voltage difference between a drain voltage of said first field-effect transistor and a drain voltage of said second field-effect transistor is detected and output.

17. A power detection circuit as set forth in claim 16, wherein:
said first field-effect transistor and said second field-effect transistor have approximately the same characteristics;
said drain bias supply circuit includes a first drain bias resistor element connected between a drain of said first field-effect transistor and a voltage source, and a second drain bias resistor element connected between a drain of said second field-effect transistor and a voltage source;
a first gate bias voltage by said first gate bias supply circuit and a second gate bias voltage by said second gate bias supply circuit are approximately same and set at approximately same voltages as threshold voltages of said first and second field-effect transistors; and
a resistance value of said first drain bias resistance element and a resistance value of said second drain bias resistor element are set to be approximately the same values.

18. A power detection circuit as set froth in claim 16, wherein:
a ratio Wga/Wgb of a gate width Wga of said first field-effect transistor and a gate width Wgb of said second field-effect transistor is set to be N;
said drain bias supply circuit includes a first drain bias resistor element connected between a drain of said first field-effect transistor and a voltage source, and a second drain bias resistor element connected between a drain of said second field-effect transistor and a voltage source;
a first gate bias voltage by said first gate bias supply circuit and a second gate bias voltage by said second gate bias supply circuit are approximately same and set at approximately same voltages as threshold voltages of said first and second field-effect transistors; and
a resistance value Ra of said first drain bias resistor element and a resistance value Rb of said second drain bias resistor element are set to satisfy a condition of Ra/Rb = 1/N.

19. A power detection circuit as set forth in claim 16, wherein said current source includes a resistor element.

20. A power detection circuit as set forth in claim 16, wherein said current source comprises
a third field-effect transistor connected between a connection point of sources of said first field-effect transistor and said second field-effect transistor and a reference potential, and
a third gate bias supply circuit for supplying a gate bias voltage to a gate of said third field-effect transistor.

21. A demodulator, comprising:
a first signal input terminal for receiving a first radio-frequency signal;
a second signal input terminal for receiving a second radio-frequency signal;
a generation means for generating two radio-frequency signals having a phase difference based on at least one of the first radio-frequency signal input from said first signal input terminal and the second radio-frequency signal input from said second signal input terminal, including at least one output terminal for outputting the generated radio-frequency signals;
at least one power detection circuit for receiving the radio-frequency signal output from the output terminal of said generation means and detecting a signal level of the input radio-frequency signal; and
a conversion circuit for converting an output signal of said power detection circuit to a plurality of signal components included in said first or second radio-frequency signal;
wherein said power detection circuit comprises:
a first field-effect transistor having a gate supplied with said radio-frequency signal;
a second field-effect transistor having a source connected to a source of said first field-effect transistor;
a first gate bias supply circuit for supplying a gate bias voltage to a gate of said first field-effect transistor;
a second gate bias supply circuit for supplying a gate bias voltage to a gate of said second field-effect transistor;
a current source connected between a connection point of sources of said first field-effect transistor and said second field-effect transistor and a reference potential;
a first capacitor connected in parallel with said current source between a connection point of sources of said first field-effect transistor and said second field-effect transistor and a reference potential;
a drain bias supply circuit for supplying a drain bias voltage to drains of said first field-effect transistor and said second field-effect transistor;
a second capacitor connected between a drain of said first field-effect transistor and a reference potential; and
a third capacitor connected between a drain of said second field-effect transistor and a reference potential;
wherein a voltage difference between a drain voltage of said first field-effect transistor and a drain voltage of said second field-effect transistor is regarded as a detection output.

22. A demodulator as set forth in claim 21, wherein, in said power detection circuit,
said first field-effect transistor and said second field-effect transistor have approximately same characteristics;
said drain bias supply circuit includes a first drain bias resistor element connected between a drain of said first field-effect transistor and a voltage source, and a second drain bias resistor element connected between a drain of said second field-effect transistor and a voltage source;
a resistance value of said first drain bias resistance element and a resistance value of said second drain bias resistor element are set to be approximately same values; and
a capacitance value of said second capacitor and a capacitance value of said third capacitor are set to be approximately same values.

23. A demodulator as set froth in claim 21, wherein, in said power detection circuit,
a ratio Wga/Wgb of a gate width Wga of said first field-effect transistor and a gate width Wgb of said second field-effect transistor is set to be N;
said drain bias supply circuit includes a first drain bias resistor element connected between a drain of said first field-effect transistor and a voltage source, and a second drain bias resistor element connected between a drain of said second field-effect transistor and a voltage source;
a first gate bias voltage by said first gate bias supply circuit and a second gate bias voltage by said second gate bias supply circuit are set to be approximately same;
a resistance value Ra of said first drain bias resistor element and a resistance value Rb of said second drain bias resistor element are set to satisfy a condition of Ra/Rb = 1/N; and
a capacitance value of said second capacitor and a capacitance value of said third capacitor are set to be approximately same values.

24. A demodulator as set forth in claim 21, wherein
said drain bias supply circuit can set a level of a drain bias voltage to a level in accordance with a control signal;
further comprising:
a level detection circuit for detecting a reception signal level by a detection output of said power detection circuit; and
a control circuit for generating said control signal to set said drain bias voltage to be supplied in accordance with a reception signal level detected in the level detection circuit and outputting to said drain bias supply circuit.

25. A demodulator as set forth in claim 24, wherein
when a reception signal level is lower than a predetermined level, said control circuit outputs said control signal to set said drain bias voltage to be lower than that at the predetermined level.

26. A demodulator as set forth in claim 21, wherein said current source of said current detection circuit includes a resistor element.

27. A demodulator as set forth in claim 21, wherein said current source of said current detection circuit comprises
a third field-effect transistor connected between a connection point of sources of said first field-effect transistor and said second field-effect transistor and a reference potential, and
a third gate bias supply circuit for supplying a gate bias voltage to a gate of said third field-effect transistor.

28. A demodulator, comprising:
a first signal input terminal for receiving a first radio-frequency signal;
a second signal input terminal for receiving a second radio-frequency signal;
a generation means for generating two radio-frequency signals having a phase difference based on at least one of the first radio-frequency signal input from said first signal input terminal and the second radio-frequency signal input from said second signal input terminal, including at least one output terminal for outputting the generated radio-frequency signals;
at least one power detection circuit for receiving the radio-frequency signal output from the output terminal of said generation means and detecting a signal level of the input radio-frequency signal; and
a conversion circuit for converting an output signal of said power detection circuit to a plurality of signal components included in said first or second radio-frequency signal;
wherein said power detection circuit comprises:
a first field-effect transistor having a gate supplied with said radio-frequency signal;
a second field-effect transistor having a source connected to a source of said first field-effect transistor;
a first gate bias supply circuit for supplying a gate bias voltage to a gate of said first field-effect transistor;
a second gate bias supply circuit for supplying a gate bias voltage to a gate of said second field-effect transistor;
a current source connected between a connection point of sources of said first field-effect transistor and said second field-effect transistor and a reference potential;
a first capacitor connected in parallel with said current source between a connection point of sources of said first field-effect transistor and said second field-effect transistor and a reference potential;
a drain bias supply circuit for supplying a drain bias voltage to drains of said first field-effect transistor and said second field-effect transistor; and
a second capacitor connected between a drain of said first field-effect transistor and a drain of said second field-effect transistor,
wherein a voltage difference between a drain voltage of said first field-effect transistor and a drain voltage of said second field-effect transistor is regarded as a detection output.

29. A demodulator as set forth in claim 28, wherein, in said power detection circuit,
said first field-effect transistor and said second field-effect transistor have approximately same characteristics;
said drain bias supply circuit includes a first drain bias resistor element connected between a drain of said first field-effect transistor and a voltage source, and a second drain bias resistor element connected between a drain of said second field-effect transistor and a voltage source; and
a resistance value of said first drain bias resistance element and a resistance value of said second drain bias resistor element are set to be approximately same values.

30. A demodulator as set froth in claim 28, wherein, in said power detection circuit,
a ratio Wga/Wgb of a gate width Wga of said first field-effect transistor and a gate width Wgb of said second field-effect transistor is set to be N;
said drain bias supply circuit includes a first drain bias resistor element connected between a drain of said first field-effect transistor and a voltage source, and a second drain bias resistor element connected between a drain of said second field-effect transistor and a voltage source;
a first gate bias voltage by said first gate bias supply circuit and a second gate bias voltage by said second gate bias supply circuit are set to be approximately same; and
a resistance value Ra of said first drain bias resistor element and a resistance value Rb of said second drain bias resistor element are set to satisfy a condition of Ra/Rb = 1/N.

31. A demodulator as set forth in claim 28, wherein
said drain bias supply circuit can set a level of a drain bias voltage to a level in accordance with a control signal;
further comprising:
a level detection circuit for detecting a reception signal level by a detection output of said power detection circuit; and
a control circuit for generating said control signal to set said drain bias voltage to be supplied in accordance with a reception signal level detected in the level detection circuit and outputting to said drain bias supply circuit.

32. A demodulator as set forth in claim 31, wherein
when a reception signal level is lower than a predetermined level, said control circuit outputs said control signal to set said drain bias voltage to be lower than that at the predetermined level.

33. A demodulator as set forth in claim 28, wherein said current source of said current detection circuit includes a resistor element.

34. A demodulator as set forth in claim 28, wherein said current source of said current detection circuit comprises
a third field-effect transistor connected between a connection point of sources of said first field-effect transistor and said second field-effect transistor and a reference potential, and
a third gate bias supply circuit for supplying a gate bias voltage to a gate of said third field-effect transistor.

35. A demodulator, comprising:
a first signal input terminal for receiving a first radio-frequency signal;
a second signal input terminal for receiving a second radio-frequency signal;
a generation means for generating two radio-frequency signals having a phase difference based on at least one of the first radio-frequency signal input from said first signal input terminal and the second radio-frequency signal input from said second signal input terminal, including at least one output terminal for outputting the generated radio-frequency signals;
at least one power detection circuit for receiving the radio-frequency signal output from the output terminal of said generation means and detecting a signal level of the input radio-frequency signal; and
a conversion circuit for converting an output signal of said power detection circuit to a plurality of signal components included in said first or second radio-frequency signal;
wherein said power detection circuit comprises:
a first field-effect transistor having a gate supplied with said radio-frequency signal;
a second field-effect transistor having a gate supplied with said radio-frequency signal and a source connected to a source of said first field-effect transistor;
a first gate bias supply circuit for supplying a gate bias voltage to a gate of said first field-effect transistor;
a second gate bias supply circuit for supplying a gate bias voltage to a gate of said second field-effect transistor;
a current source connected between a connection point of sources of said first field-effect transistor and said second field-effect transistor and a reference potential;
a first capacitor connected in parallel with said current source between a connection point of sources of said first field-effect transistor and said second field-effect transistor and a reference potential;
a drain bias supply circuit for supplying a drain bias voltage to drains of said first field-effect transistor and said second field-effect transistor;
a second capacitor connected between a drain of said first field-effect transistor and a reference potential; and
a third capacitor connected between a drain of said second field-effect transistor and a reference potential,
wherein a voltage difference between a drain voltage of said first field-effect transistor and a drain voltage of said second field-effect transistor is regarded as a detection output.

36. A demodulator as set forth in claim 35, wherein, in said power detection circuit,
said first field-effect transistor and said second field-effect transistor have approximately the same characteristics;
said drain bias supply circuit includes a first drain bias resistor element connected between a drain of said first field-effect transistor and a voltage source, and a second drain bias resistor element connected between a drain of said second field-effect transistor and a voltage source;
a resistance value of said first drain bias resistance element and a resistance value of said second drain bias resistor element are set to be approximately same values; and
a capacitance value of said second capacitor and a capacitance value of said third capacitor are set to be approximately same values.

37. A demodulator as set froth in claim 35, wherein, in said power detection circuit,
a ratio Wga/Wgb of a gate width Wga of said first field-effect transistor and a gate width Wgb of said second field-effect transistor is set to be N;
said drain bias supply circuit includes a first drain bias resistor element connected between a drain of said first field-effect transistor and a voltage source, and a second drain bias resistor element connected between a drain of said second field-effect transistor and a voltage source;
a first gate bias voltage by said first gate bias supply circuit and a second gate bias voltage by said second gate bias supply circuit are set to be approximately same;
a resistance value Ra of said first drain bias resistor element and a resistance value Rb of said second drain bias resistor element are set to satisfy a condition of Ra/Rb = 1/N; and
a capacitance value of said second capacitor and a capacitance value of said third capacitor are set to be approximately same values.

38. A demodulator as set forth in claim 35, wherein
said drain bias supply circuit can set a level of a drain bias voltage to a level in accordance with a control signal;
further comprising:
a level detection circuit for detecting a reception signal level by a detection output of said power detection circuit; and
a control circuit for generating said control signal to set said drain bias voltage to be supplied in accordance with a reception signal level detected in the level detection circuit and outputting to said drain bias supply circuit.

39. A demodulator as set forth in claim 38, wherein
when a reception signal level is lower than a predetermined level, said control circuit outputs said control signal to set said drain bias voltage to be lower than that at the predetermined level.

40. A demodulator as set forth in claim 35, wherein said current source of said current detection circuit includes a resistor element.

41. A demodulator as set forth in claim 35, wherein said current source of said current detection circuit comprises
a third field-effect transistor connected between a connection point of sources of said first field-effect transistor and said second field-effect transistor and a reference potential, and
a third gate bias supply circuit for supplying a gate bias voltage to a gate of said third field-effect transistor.

42. A demodulator, comprising:
a first signal input terminal for receiving a first radio-frequency signal;
a second signal input terminal for receiving a second radio-frequency signal;
a generation means for generating two radio-frequency signals having a phase difference based on at least one of the first radio-frequency signal input from said first signal input terminal and the second radio-frequency signal input from said second signal input terminal, including at least one output terminal for outputting the generated radio-frequency signals;
at least one power detection circuit for receiving the radio-frequency signal output from the output terminal of said generation means and detecting a signal level of the input radio-frequency signal; and
a conversion circuit for converting an output signal of said power detection circuit to a plurality of signal components included in said first or second radio-frequency signal,
wherein said power detection circuit comprises:
a first field-effect transistor having a gate supplied with said radio-frequency signal;
a second field-effect transistor having a gate supplied with a radio-frequency signal and a source connected to a source of said first field-effect transistor;
a first gate bias supply circuit for supplying a gate bias voltage to a gate of said first field-effect transistor;
a second gate bias supply circuit for supplying a gate bias voltage to a gate of said second field-effect transistor;
a current source connected between a connection point of sources of said first field-effect transistor and said second field-effect transistor and a reference potential;
a first capacitor connected in parallel with said current source between a connection point of sources of said first field-effect transistor and said second field-effect transistor and a reference potential;
a drain bias supply circuit for supplying a drain bias voltage to drains of said first field-effect transistor and said second field-effect transistor;
a second capacitor connected between a drain of said first field-effect transistor and a drain of said second field-effect transistor; and
wherein a voltage difference between a drain voltage of said first field-effect transistor and a drain voltage of said second field-effect transistor is regarded as a detection output.

43. A demodulator as set forth in claim 42, wherein, in said power detection circuit,
said first field-effect transistor and said second field-effect transistor have approximately the same characteristics;
said drain bias supply circuit includes a first drain bias resistor element connected between a drain of said first field-effect transistor and a voltage source, and a second drain bias resistor element connected between a drain of said second field-effect transistor and a voltage source;
a first gate bias voltage by said first gate bias supply circuit and a second gate bias voltage by said second gate bias supply circuit are approximately same and set at approximately same voltages as threshold voltages of said first and second field-effect transistors; and
a capacitance value of said second capacitor and a capacitance value of said second drain bias resistor element are set to be approximately the same values.

44. A demodulator as set froth in claim 42, wherein, in said power detection circuit,
a ratio Wga/Wgb of a gate width Wga of said first field-effect transistor and a gate width Wgb of said second field-effect transistor is set to be N;
said drain bias supply circuit includes a first drain bias resistor element connected between a drain of said first field-effect transistor and a voltage source, and a second drain bias resistor element connected between a drain of said second field-effect transistor and a voltage source;
a first gate bias voltage by said first gate bias supply circuit and a second gate bias voltage by said second gate bias supply circuit are approximately same and set at approximately same voltages as threshold voltages of said first and second field-effect transistors; and
a resistance value Ra of said first drain bias resistor element and a resistance value Rb of said second drain bias resistor element are set to satisfy a condition of Ra/Rb = 1/N.

45. A demodulator as set forth in claim 42, wherein
said drain bias supply circuit can set a level of a drain bias voltage to a level in accordance with a control signal;
further comprising:
a level detection circuit for detecting a reception signal level by a detection output of said power detection circuit; and
a control circuit for generating said control signal to set said drain bias voltage to be supplied in accordance with a reception signal level detected in the level detection circuit and outputting to said drain bias supply circuit.

46. A demodulator as set forth in claim 45, wherein
when a reception signal level is lower than a predetermined level, said control circuit outputs said control signal to set said drain bias voltage to be lower than that at the predetermined level.

47. A demodulator as set forth in claim 42, wherein said current source of said current detection circuit includes a resistor element.

48. A demodulator as set forth in claim 42, wherein said current source of said current detection circuit comprises
a third field-effect transistor connected between a connection point of sources of said first field-effect transistor and said second field-effect transistor and a reference potential, and
a third gate bias supply circuit for supplying a gate bias voltage to a gate of said third field-effect transistor.
